# EUROPÄISCHE PATENTSCHRIFT

(11) **EP 3 913 469 B1**
(45) Veröffentlichungstag und Bekanntmachung des Hinweises auf die Patenterteilung: **01.10.2025**
(21) Anmeldenummer: 21172187.3
(22) Anmeldetag: 05.05.2021
(51) Int. Cl.: G06F 3/01, G01R 1/02, G06F 3/04883

(54) **ELEKTRONISCHES LABOR- UND PRÜFGERÄT UND VERFAHREN ZUM BETREIBEN EINES SOLCHEN**
ELECTRONIC LABORATORY AND TEST APPARATUS AND METHOD FOR OPERATING THE SAME
APPAREIL ÉLECTRONIQUE DE LABORATOIRE ET D'ESSAI ET PROCÉDÉ DE FONCTIONNEMENT D'UN TEL APPAREIL

(30) Priorität: 23.05.2020 DE 102020113863
(43) Veröffentlichungstag der Anmeldung: 24.11.2021
(73) Patentinhaber: Fischer, Andreas, 72250 Freudenstadt (DE)
(72) Erfinder: Fischer, Andreas, 72250 Freudenstadt (DE)
(74) Vertreter: Manitz Finsterwald Patent- und Rechtsanwaltspartnerschaft mbB

(56) Entgegenhaltungen:
- WO-A1-2018/232404
- DE-A1- 102012 215 768
- US-A1- 2008 048 878
- US-A1- 2013 293 504
- US-A1- 2019 294 258
- ANONYMOUS: "MGC3030/3130 3D Tracking and Gesture Controller Data Sheet. 2019 (DS40001667F)", MICROCHIP TECHNOLOGY INC., 1 January 2019 (2019-01-01), pages 1 - 51, XP055809452, Retrieved from the Internet <URL:http://ww1.microchip.com/downloads/en/DeviceDoc/MGC3030-3130-3D-Tracking-and-Gesture-Controller-40001667F.pdf>
- ANONYMOUS: "MSP430 CapTIvate(TM) The easiest-to-use capacitive touch MCU", 31 December 2018 (2018-12-31), pages 1 - 52, XP093035093, Retrieved from the Internet <URL:https://www.ti.com/lit/ml/sszp244/sszp244.pdf?ts=1679934578227&ref_url=https%3A%2F%2Fwww.google.com%2F> [retrieved on 20230327]

## Beschreibung

Die vorliegende Erfindung betrifft ein elektronisches Labor- und Prüfgerät, nachstehend auch kurz "Gerät", insbesondere für ein Elektroniklabor. Die Erfindung betrifft ferner ein Verfahren zum Betreiben eines solchen Geräts.

Derartige Geräte werden beispielsweise an Arbeitsplätzen in Labor- oder Unterrichtsräumen oder an sonstigen Mess- und Entwicklungsarbeitsplätzen verwendet. Sie können aber auch in Prüffeldern und/oder an Montagearbeitsplätzen zum Einsatz gelangen. Diese Geräte können die unterschiedlichsten Funktionalitäten bereitstellen, die an den genannten Arbeitsplätzen benötigt werden. Mittels Gesten steuerbare elektronische Labor- und Prüfgeräte sind u.a. aus den Patentschriften WO 2018/232404 A1 und US 2013/293504 A1 bekannt. Aus der Patentschrift US 2008/048878 A1 ist ein Verfahren zur Auswahl einer Menüoption aus einem mehrere Optionen umfassenden Menü zur Steuerung eines Kopfhörers mittels einer berührungslosen Rotationsgeste, sowie die Bestätigung der ausgewählten Menüoption mittels eines Verharrens bekannt.

Insbesondere in Unterrichtsräumen und generell an Arbeitsplätzen mit wechselnden Benutzern ergibt sich häufig durch Berührung des Geräts zu dessen Bedienung durch verschiedene Benutzer ein gewisses Risiko zur Übertragung von Keimen, wie etwa Viren. Mit der Benutzung durch mehrere Benutzer geht also ein Infektionsrisiko einher. Es ist eine Aufgabe der Erfindung, die Verwendung und Bedienung eines elektronischen Labor- und Prüfgeräts im Hinblick auf die Hygiene zu verbessern und/oder ein Infektionsrisiko bei der Benutzung durch verschiedene Benutzer zu reduzieren.

Es ist eine weitere Aufgabe der Erfindung, die Bedienung eines elektronischen Labor- und Prüfgeräts eingangs genannter Art besonders einfach zu gestalten und insbesondere hierdurch die Arbeitsabläufe des Bedieners effizienter zu gestalten.

Diese Aufgabe wird durch ein elektronisches Labor- und Prüfgerät mit den Merkmalen gemäß Anspruch 1 gelöst.

Da die berührungslose Gestensteuerung keine Berührung des Geräts erfordert, ist für die betreffende Steuerungsaktion ein Infektionsrisiko reduziert. Dies gilt auch dann, wenn das Gerät neben der berührungslosen Steuerung unter Berührung des Geräts steuerbar ist, da jede Vermeidung einer Berührung einen Beitrag zur Reduktion des Gesamtrisikos leistet.

Die Steuerung bzw. Bedienung des Geräts ist aufgrund der Erfindung besonders einfach und komfortabel. Zudem lässt sich die Bedienung hierdurch besonders flexibel gestalten. So kann das Gerät etwa ein, insbesondere berührungsempfindliches, Bedienelement und/oder einen berührungsempfindlichen Bildschirm aufweisen, über welche das Gerät ebenfalls steuerbar ist. Die berührungslose Gestensteuerung erlaubt dabei auf einfache und komfortable Weise zusätzliche Steuerungsmöglichkeiten.

Insbesondere kann das Gerät dazu eingerichtet sein, mehrere vorbestimmte, berührungslose Gesten zu erkennen. Die vorbestimmten Gesten können vielfältig ausgebildet sein und grundsätzlich der Steuerung einer bestimmten Funktion und/oder einem bestimmten Funktionsmodul des Geräts permanent zugeordnet sein oder verschiedenen Funktionen wahlweise zuordenbar sein. Eine Zuordnung kann beispielsweise auch nutzerabhängig oder profilabhängig festgelegt oder festlegbar sein. So kann etwa für einen bestimmten Nutzer, dessen Arbeitsabläufe sich häufig wiederholen, wenigstens eine bestimmte berührungslose Geste zur Steuerung einer bestimmten Funktion programmiert werden, sodass der Nutzer diese Funktion stets nach Belieben durch eine berührungslose Geste steuern kann, unabhängig davon, in welchem Betriebszustand sich das Gerät gerade befindet und/oder welche Informationen gerade an einem Bildschirm des Geräts angezeigt werden. So ist es etwa denkbar, dass eine bestimmte Geste, z.B. Kreisen der Hand, stets oder zumindest nutzer- oder profilabhängig eine Steuerung einer Spannungsausgabe eines Netzteils des Geräts bewirkt.

Gemäß einer vorteilhaften Ausführungsform ist vorgesehen, dass eine berührungslose Geste, durch die das Gerät steuerbar ist, eine Translationsgeste ist, insbesondere eine Wischgeste. Eine solche lässt sich von einem Bediener typischerweise relativ einfach mit recht hohem Präzisionsgrad ausführen, sodass eine gezielte Steuerung möglich ist. Eine Translationsgeste kann beispielsweise vertikal und/oder horizontal ausgerichtet sein.

Eine berührungslose Geste, durch die das Gerät steuerbar ist, ist eine Rotationsgeste, insbesondere eine Kreisgeste. Eine solche ist ebenfalls mit recht hohem Präzisionsgrad einfach ausführbar, sodass eine gezielte Steuerung möglich ist. Unter einer Kreisgeste ist eine kreisende Bewegung der Hand des Bedieners zu verstehen.

Grundsätzlich versteht es sich, dass ein Bediener seine Hand bei der Ausführung einer Steuerungsgeste typischerweise nicht exakt auf einer mathematisch vordefinierten Bahn bewegen kann, also beispielsweise nicht exakt vertikal, horizontal, in einer bestimmten Ebene oder auf einer Kreisbahn. Folglich beziehen sich derartige Angaben in dieser Anmeldung auf einen Genauigkeitsgrad, der bei Handbewegungen zuverlässig erreichbar ist. Typischerweise ist eine Steuerung des Geräts oder ein Gestensensor selbst dazu eingerichtet, Ungenauigkeiten der Bewegung zu beurteilen und im Rahmen von bestimmten Grenzen eine Steuerungsgeste dennoch als solche zu erkennen. Eine Geste kann beispielsweise auch in Form eines Korridors definiert sein. Grundsätzlich kann beispielsweise ein bestimmter Bezugspunkt an der Hand des Bedieners maßgeblich sein, beispielsweise eine Fingerspitze und/oder ein dem Gerät nächstes Ende der Hand.

Erfindungsgemäß weist das Gerät ein zumindest teilweise ebenes Außenteil auf und sieht vor, dass eine berührungslose Geste zur Steuerung des Geräts eine Bewegung parallel zur Erstreckungsebene des Außenteils umfasst. Somit ist für den Bediener ein räumliches Bezugssystem bereitgestellt, sodass dieser die Geste auf einfache Weise am Außenteil bzw. seiner Erstreckungsebene ausrichten kann. Insbesondere kann die Geste eine Translationsbahn und/oder eine Rotationsbahn parallel zu der Erstreckungsebene umfassen. Auch hier, wie auch in der gesamten Anmeldung, ist die parallele Bewegung nicht als mathematisch exakt parallele Bewegung zu verstehen, sondern als eine annähernd parallele Bewegung, mit einem Genauigkeitsgrad, der bei Handbewegungen zuverlässig erreichbar ist.

Bei dem Außenteil handelt es sich um eine Frontplatte des Geräts, an der beispielsweise auch ein Bildschirm, ein oder mehrere Bedienelemente und/oder verschiedene Anschlüsse angeordnet sein können. Die Frontplatte kann bevorzugt aus Glas hergestellt sein, beispielsweise aber auch aus Metall oder Kunststoff.

Bevorzugt kann das Gerät zur Erkennung von Gesten in zwei oder sogar in drei Raumrichtungen eingerichtet sein. Bei der Erkennung von lediglich zwei Raumrichtungen erstrecken sich diese bevorzugt parallel zur Erstreckungsebene des Außenteils. Bei drei Raumrichtungen erstrecken sich ebenfalls bevorzugt zwei Raumrichtungen parallel zur Erstreckungsebene des Außenteils und die dritte Raumrichtungen senkrecht zu dieser Ebene. In diesem Kontext kann eine jeweilige berührungslose Geste selbst beispielsweise lediglich eindimensional sein, dies ist beispielsweise bei einer exakt geraden Translationsgeste in exakt einer Raumrichtung der Fall. Es können auch mehrere eindimensionale Gesten für verschiedene Raumrichtungen definiert sein.

Mit besonderem Vorteil kann es ferner vorgesehen sein, dass das Gerät durch zweidimensionale und/oder dreidimensionale berührungslose Gesten steuerbar ist. Als zweidimensionale Gesten sind solche zu verstehen, die in einer Ebene ablaufen. Die Ebene kann bevorzugt parallel zur Erstreckungsebene des Außenteils ausgerichtet sein. Eine in dieser Ebene ablaufende Kreisgeste ist beispielsweise eine zweidimensionale Geste. Dreidimensionale Gesten umfassen hingegen Bewegungen in allen drei Raumdimensionen. Denkbar ist hier beispielsweise, dass die Hand des Bedieners eine Schraubenbahn beschreibt.

Gemäß einem weiteren vorteilhaften Beispiel kann es vorgesehen sein, dass wenigstens ein Paar von Gesten definiert ist, welche auf derselben Bahn verlaufen aber in ihrer Richtung entgegengesetzt sind. Dabei können die Gesten bevorzugt so definiert sein, dass ihre Steuerungsfunktionen ebenfalls einander entgegengesetzt sind. So kann beispielsweise eine erste Geste des Paars in einer ersten Richtung dazu eingerichtet sein, eine Funktion zu aktivieren, wobei eine zweite Geste des Paars in einer zweiten, der ersten entgegengesetzten Richtung dazu eingerichtet ist, die Funktion zu deaktivieren.

Grundsätzlich kann die Gestensteuerung auch zur Steuerung einer graduell einstellbaren Funktion eingerichtet sein, d.h. dass die Funktion zwischen mehr als zwei Zuständen oder Werten, insbesondere über einen Wertebereich, einstellbar ist. Typischerweise umfasst die Funktion ein Intervall von möglichen Werten für eine bestimmte Größe und mittels der Geste ist der Wert innerhalb dieses Intervalls einstellbar. Dabei kann der Wert grundsätzlich stufenweise oder quasi kontinuierlich einstellbar sein, "quasi" deshalb, da es in digitalen Systemen typischerweise eine kleinste mögliche Auflösung gibt, sodass sich Werte typischerweise nicht ideal kontinuierlich einstellen lassen. Im Rahmen einer quasi kontinuierlichen Einstellbarkeit kann es also beispielsweise möglich sein, dass ein Zahlenwert, beispielsweise eine Spannung, mit vielen Nachkommastellen einstellbar ist.

Bei der Funktion, die mittels Gestensteuerung einzustellen ist, kann es sich beispielsweise um eine Strom- und/oder Spannungsausgabe handeln, wobei beispielsweise die Höhe von Strom und/oder Spannung über eine Geste einstellbar sind. Bei der Funktion kann es sich beispielsweise auch um eine grafische Funktion handeln, wobei mittels einer Geste zum Beispiel eine Größe und/oder ein Skalierungsfaktor der grafischen Funktion einstellbar sein kann. Bei einem weiteren Beispiel umfasst die Funktion eine Auswahl in einem Menü, insbesondere wobei mittels der Geste das Menü durchscrollbar ist. Derartige Funktionen können alternativ oder zusätzlich auch durch ein berührungsempfindliches Bedienelement und/oder ein konventionelles Bedienelement, z.B. einen Schiebe- oder Drehregler, einstellbar sein.

Beispielsweise kann auch wenigstens ein Paar von Gesten definiert sein, welche auf derselben Bahn verlaufen aber in ihrer Richtung entgegengesetzt sind und welche entgegengesetzten Einstellungen einer graduell einstellbaren Funktion zugeordnet sind. So kann es beispielsweise implementiert sein, dass eine erste Geste des Paars in einer ersten Richtung zu einer Erhöhung eines vom Gerät bereitgestellten physikalischen Parameters, beispielsweise einer Spannung, führt, wohingegen eine zweite Geste des Paars in einer zweiten Richtung zu einer Verringerung des physikalischen Parameters führt. Wenn die Bahn der Gesten des Paars beispielsweise translatorisch oder kreisförmig verläuft, kann so beispielsweise ein Schiebe- bzw. Drehregler berührungslos bzw. "in der Luft" simuliert werden. Somit lässt sich ein gewohntes Bedienkonzept mit der komfortablen berührungslosen Steuerung vorteilhaft verbinden. Über einen derart simulierten Regler können grundsätzlich beliebige, insbesondere graduell einstellbare, Funktionen des Geräts einstellbar sein.

Durch wenigstens eine berührungslose Geste kann beispielsweise eine grafische Funktion des Geräts und/oder eines Funktionsmoduls des Geräts steuerbar sein. Beispielsweise kann hierdurch eine auf einem Bildschirm angezeigte Tabelle, Liste und/oder Reihe scrollbar sein, eine auf einem Bildschirm angezeigte Diagrammauftragung in ihrer Achsenauflösung einstellbar, insbesondere zoombar, sein und/oder zwischen mehreren wählbaren Ansichten einer Anzeige- und/oder Steueroberfläche des Geräts auswählbar sein. Diese Maßnahmen erlauben auf einfache Weise eine besonders flexible Darstellung von Informationen am Bildschirm, wobei der Bediener die Darstellung einfach an seine Bedürfnisse anpassen kann.

Grundsätzlich kann das Gerät beispielsweise einen, insbesondere berührungsempfindlichen, Bildschirm aufweisen, der dazu eingerichtet ist, eine grafische Anzeige- und/oder Steueroberfläche bereitzustellen. Vorteilhafterweise kann es vorgesehen sein, dass die Anzeige- und/oder Steueroberfläche durch berührungslose Gesten steuerbar ist.

Erfindungsgemäß ist vorgesehen, dass mittels einer Rotationsgeste, besonders bevorzugt einer Kreisgeste, eines aus einer Vielzahl von auf einem Bildschirm des Geräts angezeigten Funktionselementen auswählbar ist, wobei das Gerät dazu eingerichtet ist, dass bei Durchführung der Geste die Funktionselemente in einer vorgegebenen Reihenfolge nacheinander ausgewählt werden. Dies erlaubt eine besonders einfache und gleichwohl umfangreiche Steuerung. Die automatische Auswahl der Funktionselemente nacheinander in vorgegebener Reihenfolge entspricht letztlich der Auswahl von Funktionselementen an einem PC mittels der Tabulatortaste, wobei bei der hier vorliegenden Ausführungsform der mit der Geste zurückgelegte Weg bestimmt, wie weit in der Reihenfolge der Funktionselemente fortgeschritten wird. Am PC mit der Tabulatortaste bestimmt hingegen die Anzahl der Tastenanschläge, wie weit in der Reihenfolge der Funktionselemente fortgeschritten wird.

Funktionselemente im Sinne der vorstehenden Ausführungsform können beispielsweise sein: Karteireiter, Bedienelemente, Grafikelemente, Zahlenfelder usw. Bei einem besonders vorteilhaften Beispiel können auch einzelne Ziffern und/oder Teilbereiche eines Zahlenfeldes zur individuellen Veränderung auswählbar sein, z.B. mit einer Rotationsgeste oder auch mit einer anderen Geste.

Erfindungsgemäß ist nach einer Auswahl mittels einer Rotationsgeste mittels eines Verharrens, insbesondere für wenigstens eine vorbestimmte Zeit, die Auswahl bestätigbar, insbesondere die dem Funktionselement zugeordnete Funktion endgültig auswählbar und/oder zur Veränderung und/oder Einstellung aktivierbar ist. Dies erlaubt eine einfache Steuerung.

Allgemein kann das Gerät beispielsweise ein, insbesondere berührungsempfindliches, Bedienelement aufweisen, durch welches eine Funktion des Geräts und/oder eines Funktionsmoduls des Geräts steuerbar ist. Die Steuerung mittels einer Geste und diejenige Mittels des Bedienelements können auch zur Steuerung einer bestimmten Funktion kombiniert werden. Beispielsweise kann durch das Bedienelement eine Kurve einer Diagrammauftragung relativ zu einem dargestellten Bereich der Diagrammauftragung positionierbar sein. Somit lässt sich auf einfache Weise der Bereich der Kurve auswählen, welcher dargestellt werden soll. Dabei kann beispielsweise eine berührungslose Geste vorgesehen sein, mittels der die Auflösung der Darstellung der Diagrammauftragung in einer oder mehreren Dimensionen veränderbar ist, mittels der also die Diagrammauftragung zoombar ist. Somit kann der Bediener die Darstellung der Diagrammauftragung zügig und einfach nach seinen Wünschen einstellen und insbesondere einen bestimmten Teilbereich der Diagrammauftragung schnell vergrößert darstellen lassen. Alternativ lassen sich auch unterschiedliche Gesten in diesem Sinn kombinieren, z.B. auch ohne Bedienelement.

Erfindungsgemäß ist vorgesehen, dass das Gerät einen Gestensensor zur Erfassung von berührungslosen Gesten zur Steuerung des Geräts umfasst. Hierdurch kann die Erfassung der Gesten unmittelbar durch das Gerät erfolgen. Zusätzlich kann beispielsweise ein Gestensensor an einem separaten Bedienmodul vorgesehen sein. Grundsätzlich kann das Gerät bevorzugt einen Anschluss für ein separates Bedienmodul umfassen, wobei der Anschluss allgemein für ein Bedienmodul mit Gestensensor und/oder für ein Bedienmodul ohne Gestensensor eingerichtet sein kann.

Ein Gestensensor kann beispielsweise außerdem zur Erfassung einer Berührung zur Steuerung des Geräts bzw. des Bedienmoduls ausgebildet sein. Bei einem besonders vorteilhaften Beispiel ist vorgesehen, dass das Gerät ein berührungsempfindliches Bedienelement umfasst, wobei der Gestensensor außerdem zur Erfassung einer Berührung des Bedienelements zur Steuerung des Geräts eingerichtet ist. Der Gestensensor hat somit insbesondere eine Doppelfunktion, nämlich sowohl die berührungslose Erfassung von Gesten als auch die Erfassung von Berührungen, insbesondere auch Berührungsgesten. Der Gestensensor kann grundsätzlich beispielsweise auf Basis eines elektrischen Feldes arbeiten. Dabei kann zum Beispiel das Feld aus einer Außenfläche des Geräts, zum Beispiel einer Außenfläche eines Außenteils, herausstehen, um berührungslose Gesten zu ermitteln. Dabei kann ferner mittels eines Feldbereiches, der nicht oder nur minimal aus der Außenfläche heraussteht, aber im Bereich der Außenfläche selbst aktiv ist, eine Berührung der Außenfläche zur Steuerung des Geräts festgestellt werden. Somit kann insbesondere mit ein und demselben Sensor bzw. ein und demselben Feld, insbesondere in Abhängigkeit vom Abstand der Hand zu der betreffenden Außenfläche, sowohl eine berührungslose Geste als auch eine Berührung erfasst werden.

Grundsätzlich kann der Gestensensor beispielsweise zur Erfassung der Hand eines Bedieners in einem Bereich von 0 cm bis 30 cm Abstand zu einer Referenzfläche des Geräts eingerichtet sein. Grundsätzlich können auch Gesten, insbesondere lediglich, in einem Bereich von 0 cm bis 30 cm Abstand zu einer Referenzfläche des Geräts definiert sein. Die Referenzfläche ist insbesondere durch eine Außenfläche des Geräts bzw. eines Außenteils, insbesondere eine Außenfläche einer Frontplatte, gebildet. Insoweit der Gestensensor auch zur Erfassung einer Berührung eingerichtet ist, entspricht ein Abstand von 0 cm einer Berührung. Besonders bevorzugt beträgt der Bereich lediglich von 0 cm bis 20 cm Abstand zur Referenzfläche.

Gemäß einer weiteren Ausführungsform ist vorgesehen, dass der Gestensensor dazu eingerichtet ist, ein elektrisches Feld zu erzeugen, eine Veränderung des elektrischen Feldes durch eine Hand eines Benutzers zu erkennen und in Abhängigkeit von der Veränderung eine berührungslose Geste und/oder Berührung zur Steuerung des Geräts zu ermitteln. Dies bildet ein technisch besonders einfaches Sensorprinzip, welches zudem eine präzise Steuerung erlaubt. Bei dem elektrischen Feld kann es sich insbesondere um ein elektrisches Nahfeld handeln. Bevorzugt erstreckt sich das elektrische Feld über die physischen Grenzen des Geräts hinaus, insbesondere vor einem Bedienelement und/oder einer Frontplatte. Die sensorische Erkennung auf Basis eines elektrischen Feldes ist besonders einfach und kostengünstig implementierbar insbesondere im Vergleich zu einer Gestenerkennung durch Videokameras. Vorteilhafterweise kann der Gestensensor somit als kamerafreier oder optikfreier Sensor ausgebildet sein.

Beispielsweise kann es vorgesehen sein, dass das Gerät ein Bedienelement umfasst, wobei der Gestensensor aus Sicht eines Bedieners hinter dem Bedienelement angeordnet ist. Dies erlaubt eine besonders intuitive Gestensteuerung, da der Bediener seine Geste am Bedienelement ausrichten kann.

Das Gerät kann beispielsweise einen berührungsempfindlichen Bildschirm aufweisen, der bevorzugt auf einem kapazitiven Funktionsbetrieb basierend ausgebildet sein kann. Besonders bevorzugt kann der Bildschirm auf der "projective capacity touch technology" (PCT) basierend ausgebildet sein. Der Gestensensor und/oder das Bedienelement können bevorzugt an einer bildschirmfreien Fläche des Geräts angeordnet sein.

Gemäß einer besonders vorteilhaften Ausführungsform ist vorgesehen, dass das Gerät mittels Spracheingabe steuerbar ist.

Da die Spracheingabe keine Berührung des Geräts erfordert, ist für die betreffende Steuerungsaktion ein Infektionsrisiko reduziert. Dies gilt auch dann, wenn das Gerät neben der Spracheingabe unter Berührung des Geräts steuerbar ist, da jede Vermeidung einer Berührung einen Beitrag zur Reduktion des Gesamtinfektionsrisikos leistet.

Tagtäglich suchen Arbeitgeber auf der ganzen Welt nach Maßnahmen zur Steigerung der Mitarbeiter-Effizienz, z.B. durch die Automatisierung vieler Arbeitsschritte und -prozesse. In Elektroniklaboren werden meistens beide Hände des Mitarbeiters für seine Aufgabe benötigt. Um z.B. ein Netzteil, ein Multimeter oder einen Funktionsgenerator zu bedienen, muss der Bediener eine Hand freimachen.

Durch Steuerung des Geräts mittels Spracheingabe hat der Bediener die Hände frei für weitere Tätigkeiten, wie zum Beispiel den Aufbau einer zu prüfenden Anordnung von elektrischen und/oder elektronischen Bauelementen. Die Bedienung des Geräts gestaltet sich durch die Möglichkeit der Spracheingabe zur Steuerung desselben besonders einfach und flexibel. Die Erfindung basiert damit letztlich auf der Involvierung weiterer Sinne und Fähigkeiten des Bedieners in den Arbeitsablauf. Daher ist die Gerätesteuerung mittels Spracheingabe auch bei für die Ausbildung konzipierten Geräten wichtig, damit die Auszubildenden an diese Art der Steuerung frühzeitig herangeführt werden können.

Eine berührungslose Gestensteuerung einerseits und eine Steuerung mittels Spracheingabe andererseits ermöglichen zusammen eine besonders umfassende berührungslose Steuerung des Geräts. Insbesondere ergibt sich ein synergetischer Effekt dadurch, dass beide Steuerungsarten unterschiedliche Stärken und Schwächen haben und gezielt für unterschiedliche Steuerungsaufgaben eingesetzt werden können. So kann etwa die Gestensteuerung für die Auswahl eines Funktionselements aus einer Vielzahl von Funktionselementen verwendet werden, weil die entsprechende Geste einfach so lange ausgeführt werden kann, bis das gewünschte Funktionselement ausgewählt ist. Mit einer Spracheingabe wäre dies womöglich mühsam, weil man etwa sehr oft "weiter" sagen müsste. An anderer Stelle hat allerdings die Spracheingabe ihren Vorteil. So wäre es denkbar, eine "zurück"-Funktion als Spracheingabe zu implementieren, während die Implementierung einer "zurück"-Funktion bei der Gestensteuerung beispielsweise dadurch erschwert sein kann, dass nur eine sehr begrenzte Anzahl von Gesten implementierbar ist.

Insbesondere kann das Gerät durch berührungslose Gesten und/oder mittels Spracheingabe berührungslos zumindest im Wesentlichen vollständig steuerbar sein. Dies ist äußerst vorteilhaft im Hinblick auf die Hygiene. So müssen die Flächen und Bedienelemente des Geräts zur Steuerung überhaupt nicht mehr berührt werden. Dies kann etwa in einer mit dem Gerät ausgestatteten Bildungseinrichtung die Übertragung von Keimen erheblich reduzieren. Bevorzugt ist das Gerät vollständig durch berührungslose Gesten und durch Spracheingabe steuerbar.

Gemäß einer Ausführungsform ist vorgesehen, dass das Gerät ein Mikrofon zum Empfang der Spracheingabe aufweist. Damit ist das Gerät besonders flexibel und insbesondere unabhängig von weiteren elektronischen Einheiten einsetzbar und dabei durch Spracheingabe steuerbar. Alternativ oder zusätzlich kann beispielsweise ein Mikrofon auch an einer elektronischen Einheit vorgesehen sein, welche von dem Labor- und Prüfgerät separat und mit diesem verknüpft ist, insbesondere über Funk, z.B. WLAN oder Bluetooth. Bei der elektronischen Einheit kann es sich beispielsweise um ein Smartphone handeln. Ein solches weist typischerweise ein Mikrofon auf und ist beispielsweise auch mittels eines Headsets erweiterbar. Ein Headset oder eine sonstige Form eines Mikrofons kann beispielsweise auch selbst eine separate elektronische Einheit im vorstehend beschriebenen Sinne bilden. Das heißt, das Gerät kann beispielsweise auch direkt drahtlos mit einem Headset oder Mikrofon verbunden sein. Beispielsweise kann das Gerät eine Bluetooth-Schnittstelle aufweisen und hierüber mit einem Bluetooth-fähigen Headset oder Mikrofon verbindbar sein.

Über ein Mikrofon an einer separaten elektronischen Einheit wird die Steuerung des Labor- und Prüfgeräts weiter vereinfacht und flexibilisiert. Eine Verarbeitung der Spracheingabe kann dabei grundsätzlich in dem Labor- und Prüfgerät selbst und/oder in der elektronischen Einheit, beispielsweise durch eine dedizierte Applikation, und/oder in einer weiteren, ausgelagerten externen Einheit, die über ein externes Netzwerk erreichbar ist, beispielsweise in Form eines sogenannten Cloud-Dienstes, erfolgen.

Bei einem vorteilhaften Beispiel ist vorgesehen, dass das Gerät eine Steuereinrichtung zur Verarbeitung der Spracheingabe und entsprechenden Ansteuerung des Geräts aufweist, wobei die Steuereinrichtung zum Erkennen mehrerer vordefinierter Sprachbefehle eingerichtet ist.

Eine Einrichtung zur Verarbeitung der Spracheingabe, insbesondere mit vordefinierten Sprachbefehlen, kann alternativ oder zusätzlich beispielsweise an einer separaten elektronischen Einheit, zum Beispiel einem Smartphone, vorgesehen sein. Diese kann dann beispielsweise dazu eingerichtet sein, entsprechende Steuersignale, z.B. per Funk, an eine Steuereinrichtung des Labor- und Prüfgeräts zum Ansteuern desselben zu senden.

Grundsätzlich kann die Verarbeitung der Spracheingabe und/oder eine Spracherkennung zum Beispiel durch eine vom Produkthersteller des Labor- und Prüfgeräts bereitgestellte Applikation erfolgen. Alternativ oder zusätzlich kann beispielsweise die Verarbeitung der Spracheingabe und/oder eine Spracherkennung durch eine vom Produkthersteller unabhängige Applikation und/oder von einem Betriebssystem der elektronischen Einheit bereitgestellt werden. Ferner können diese Ansätze beispielsweise auch kombiniert werden. So kann beispielsweise eine bloße Spracherkennung durch eine vom Produkthersteller unabhängige Applikation und/oder von einem Betriebssystem der elektronischen Einheit bereitgestellt werden, wobei eine Verarbeitung von durch die Spracherkennung erkannten Worten als Steuerbefehle durch eine vom Produkthersteller bereitgestellte Applikation erfolgen kann.

Das Gerät kann bevorzugt mehrere Funktionsmodule, z.B. DC-Netzteil, AC-Netzteil, Arbiträrgenerator, Datenlogger, Multimeter, Funktionsgenerator, Leistungsmesser, Hochspannungsprüfgerät, Isolationsprüfgerät, Schutzleiterprüfgerät, Ableitstromprüfgerät und/oder Funktionsprüfgerät, aufweisen. Dabei ist insbesondere zumindest ein Teil der Funktionsmodule durch berührungslose Gesten und/oder mittels Spracheingabe steuerbar, bevorzugt sind alle Funktionsmodule derart steuerbar. Die Funktionsmodule stellen insbesondere unterschiedliche Funktionalitäten bereit und/oder sind unabhängig voneinander betreibbar. In diesem Zusammenhang erweist sich eine Sprachsteuerung als besonders vorteilhaft. Das Gerät kann beispielsweise einen berührungsempfindlichen Bildschirm aufweisen, über den die Funktionsmodule wahlweise steuerbar sind. Dabei kann es insbesondere der Fall sein, dass zur Steuerung eines jeweiligen Funktionsmoduls ein Modulbereich auf einer Anzeige- und Steueroberfläche des Bildschirms angezeigt wird, wobei typischerweise dieser Modulbereich einen relativ großen Teil des Bildschirms einnimmt, beispielsweise eine Vollbildansicht bildet. Insbesondere kann es bei einem derartigen Aufbau der Fall sein, dass ein oder mehrere Funktionsmodule zu einem gegebenen Zeitpunkt nicht mit einem Modulbereich am Bildschirm angezeigt werden. Wenn der Bediener eines der zu dem gegebenen Zeitpunkt nicht angezeigten Funktionsmodule steuern möchte, müsste er normalerweise die Anzeige- und Steueroberfläche zunächst dahingehend bedienen, dass das gewünschte Funktionsmodul angezeigt wird und steuerbar ist. Durch die Sprachsteuerung sind die Funktionsmodule aber insbesondere auch dann bedienbar, wenn sie gerade nicht zur Bedienung an der Anzeige- und Steueroberfläche mit einem zugeordneten Modulbereich angezeigt sind. Hierdurch wird die Bedienung erheblich vereinfacht. Zudem erweist sich die Sprachsteuerung mitunter als besonders vorteilhaft, wenn der Bediener die Anzeige eines bestimmten Funktionsmoduls beibehalten möchte, während er ein anderes ansteuern möchte. Ein derartiges Szenario umfasst beispielsweise, dass das Gerät ein Netzteil aufweist, dessen Spannungsausgabe eingestellt werden soll. Zudem umfasst das Gerät ein Multimeter und sowohl das Netzteil als auch das Multimeter sind mit einem Prüfaufbau verbunden. Nun möchte der Bediener die Spannungsausgabe verändern und gleichzeitig die Messdaten des Multimeters "live" beobachten. Um dies zu erreichen kann beispielsweise das Multimeter am Bildschirm angezeigt werden, wobei der Bediener das Netzteil zur Veränderung der Spannung mittels Spracheingabe steuert.

Gemäß einer Weiterbildung ist zumindest ein vordefinierter Sprachbefehl zur Initiierung einer Spracheingabe vorgesehen. Hierdurch wird insbesondere vermieden, dass beiläufige Sprachäußerungen des Bedieners als Spracheingabe gewertet werden. Die Bedienung mittels Spracheingabe ist somit besonders zuverlässig. Der vordefinierte Sprachbefehl zur Initiierung einer Spracheingabe kann insbesondere eine Bezeichnung und/oder eine Wortmarke mit Bezug auf das Laborund Prüfgerät umfassen. Beispielsweise vertreibt der Anmelder zum Anmeldezeitpunkt ein Labor- und Prüfgerät unter der Marke "elneos". In diesem Zusammenhang kann ein Sprachbefehl zur Initiierung einer Spracheingabe beispielsweise lauten "hey elneos". Allgemeiner kann also der vordefinierte Sprachbefehl zur Initiierung einer Spracheingabe eine Anrede des Geräts umfassen.

Mit Vorteil kann zum Beispiel ein Sprachbefehl zur Auswahl eines von mehreren Funktionsmodulen des Geräts zur Anwendung eines weiteren Sprachbefehls auf das ausgewählte Funktionsmodul vorgesehen sein, insbesondere zur Einstellung eines Parameters des ausgewählten Funktionsmoduls. Ein Sprachbefehl zur Auswahl eines Funktionsmoduls kann beispielsweise die Nennung seines Modultyps und/oder eine dem betreffenden Funktionsmodul zugeordnete laufende Nummer umfassen. Ein beispielhafter Sprachbefehl zur Auswahl eines ersten von mehreren DC-Netzteilen des Geräts lautet "DC-Netzteil 1".

Gemäß einer weiteren Ausführungsform ist vorgesehen, dass ein Sprachbefehl zur Auswahl eines einstellbaren Parameters vorgesehen ist, der mittels eines weiteren Sprachbefehls, insbesondere einer Zahlenangabe und/oder eines Erhöhungs- und/oder Verringerungsbefehls, in ihrem Wert einstellbar ist. Es kann also insbesondere mittels einer Zahlenangabe und/oder eines absoluten Wertes der Parameter direkt auf einen gewünschten Wert einstellbar sein: "20 Volt". Alternativ oder zusätzlich können Erhöhungs- und/oder Verringerungsbefehle implementiert sein, mittels denen der Parameter relativ zu einem aktuellen Wert desselben einstellbar ist. Dabei kann ferner vorgesehen sein, dass mittels einer Zahlenangabe vorgebbar ist, um welchen Betrag der Parameter verändert wird: "plus 5 Volt", "erhöhe um 10 Volt", "minus 3,5 Volt". Alternativ oder zusätzlich kann beispielsweise auch eine Veränderung um einen Standardwert vorgesehen sein, sodass ein Befehl z.B. keine Zahlenangabe aufweist: "erhöhe Spannung", "verringere Strom".

Grundsätzlich bezieht sich der Begriff "weiter" im Zusammenhang eines "weiteren Sprachbefehls" lediglich darauf, dass wenigstens noch ein Sprachbefehl vorgesehen ist. Der weitere Sprachbefehl erfolgt nicht notwendigerweise zeitlich nach dem in Bezug genommenen Sprachbefehl, insbesondere dem Sprachbefehl zur Auswahl eines Funktionsmoduls bzw. Parameters. Dies lässt sich beispielhaft anhand einer Aktivierung eines Funktionsmoduls mittels Sprachsteuerung illustrieren. So kann beispielsweise der Bediener sagen: "aktiviere DC-Netzteil 1". Dabei bildet der Sprachbefehl "DC-Netzteil 1" einen solchen zur Auswahl eines von mehreren Funktionsmodulen, wobei ein weiterer Sprachbefehl "aktiviere" auf das ausgewählte Funktionsmodul angewendet werden soll. Der "weitere Sprachbefehl" steht hier also zeitlich vor dem Sprachbefehl zur Auswahl eines von mehreren Funktionsmodulen. Alternativ kann der weitere Sprachbefehl aber selbstverständlich auch zeitlich nach dem in Bezug genommenen Sprachbefehl erwartet werden. Im Zusammenhang mit dem vorstehenden Beispiel kann eine Spracheingabe des Bedieners beispielsweise lauten: "DC Netzteil 1 einschalten". Ein Beispiel mit Bezug auf einen Sprachbefehl zur Auswahl eines einstellbaren Parameters umfasst, dass eine von einem Netzteil bereitgestellte Spannung eingestellt werden soll. So kann eine Spracheingabe beispielsweise lauten "DC-Netzteil 1 20 Volt". Hierbei ist zunächst ein Sprachbefehl zur Auswahl des Funktionsmoduls DC Netzteil 1 vorgesehen, wobei der Rest der Spracheingabe "20 Volt" auf dieses Funktionsmodul angewendet wird. Die Spracheingabe "Volt" bildet ferner einen Sprachbefehl zur Auswahl eines einstellbaren Parameters, nämlich der Spannung, des Geräts, hier des Funktionsmoduls DC-Netzteil 1. Die Spracheingabe "20" bildet einen weiteren Sprachbefehl, mit dem der ausgewählte Parameter, also die Spannung, einstellbar ist.

Mit Vorteil kann es vorgesehen sein, dass die Erkennung eines weiteren Sprachbefehls in Abhängigkeit von einem ersten Sprachbefehl, beispielsweise einem Sprachbefehl zur Auswahl eines Funktionsmoduls oder eines einstellbaren Parameters, angepasst wird. Hierdurch kann die Erkennungsrate verbessert werden. Wenn beispielsweise ein Funktionsmodul oder ein Parameter ausgewählt ist, sind nur dazu "passende" weitere Spracheingaben möglich, d.h. die Spracheingabe wird nur mit einer zum ausgewählten Funktionsmodul bzw. Parameter passenden Liste von zulässigen Sprachbefehlen verglichen.

Ein mittels Spracheingabe einstellbarer Parameter kann beispielsweise eine physikalische Größe, beispielsweise Spannung und/oder Stromstärke, betreffen, welche von dem Gerät bereitgestellt werden soll. Dabei kann die Spracheingabe auch lediglich die Einheit der physikalischen Größe ausreichen lassen. Z.B. dient die Spracheingabe "Volt" zur Auswahl der physikalischen Größe Spannung. Der Parameter kann beispielsweise auch eine grafische Funktion des Geräts betreffen, wie beispielsweise eine Ansichtsauswahl oder eine Skalierung eines an einem Bildschirm angezeigten Diagramms.

Gemäß einer Weiterbildung ist vorgesehen, dass ein Sprachbefehl zum Einstellen eines zeitlichen Verlaufs eines Parameters, insbesondere einer physikalischen Größe, vorgesehen ist. Hierdurch ergibt sich eine besonders flexible aber weiterhin einfache Steuerung des Geräts. Zum Beispiel kann ein Sprachbefehl für eine Rampe, eine Steigung, eine Sinusfunktion oder ähnliches vorgesehen sein. Insbesondere kann auch ein Sprachbefehl für eine Zeitdauer vorgesehen sein, über die ein ausgewählter Parameter eine bestimmte Eigenschaft, insbesondere einen bestimmten Wert oder Verlauf haben soll. Bevorzugt können diese Sprachbefehle mit weiteren Sprachbefehlen für eine weitergehende Parametrisierung der gewünschten zeitlichen Verläufe verknüpfbar sein. So kann das Gerät beispielsweise bei einem Sprachbefehl für eine Sinusfunktion einen weiteren Sprachbefehl, beispielsweise eine Zahlenangabe für eine Frequenz und/oder Amplitude, entgegennehmen.

Bei einem weiteren vorteilhaften Beispiel ist ein Sprachbefehl vorgesehen, mittels dessen ein Eingang und/oder ein Ausgang des Geräts ein- und/oder ausschaltbar ist. Ein Ausgang kann beispielsweise vorgesehen sein, um eine Spannung und/oder einen Strom für einen Prüfaufbau bereitzustellen. Ein Eingang kann insbesondere vorgesehen sein, um im Gerät eine am Eingang anliegende Spannung und/oder einen am Eingang fließenden Strom zu messen. Es kann beispielsweise auch ein Sprachbefehl vorgesehen sein, mittels dessen ein Eingang und/oder ein Ausgang des Geräts einem Funktionsmodul wahlweise zuordenbar ist. Bei dem Ein- und/oder Ausgang handelt es sich insbesondere um einen Anschluss, insbesondere für ein Kabel eines Prüfaufbaus. Bevorzugt kann der Ein- bzw. Ausgang als Buchse ausgebildet sein.

Gemäß einer weiteren Ausgestaltung ist vorgesehen, dass das Gerät eine Tonausgabeeinrichtung zur Ausgabe von akustischem Feedback, insbesondere nach einer Spracheingabe, aufweist. Hierdurch wird die Bedienung weiter vereinfacht. Insbesondere muss der Bediener nach einer Spracheingabe nicht auf einen Bildschirm des Geräts schauen, um zu verifizieren, dass seine Spracheingabe erfolgreich war. Vielmehr kann das Feedback insbesondere eine Bestätigung einer Einstellung, eine Information, dass eine Spracheingabe nicht verstanden wurde, und/oder eine Information, dass eine Einstellung nicht vorgenommen werden konnte, umfassen.

Ein Verfahren zum Betreiben eines elektronischen Labor- und Prüfgeräts, insbesondere für ein Elektroniklabor, nach hierin beschriebener Art kann vorteilhafter Weise umfassen, dass das Gerät aufgrund von erkannten Spracheingaben den Spracheingaben zugeordnete Funktionen ausführt.

Die Aufgabe der Erfindung wird auch gelöst durch ein System nach dem hierauf gerichteten, unabhängigen Anspruch 11. Dieses umfasst ein elektronisches Laborund Prüfgerät, insbesondere für ein Elektroniklabor, nach vorstehend beschriebener Art und einen Gestensensor zur Erfassung von berührungslosen Gesten zur Steuerung des Geräts, wobei der Gestensensor am Gerät und/oder an einem von dem Gerät separaten und mit diesem, z.B. über einen Anschluss und/oder eine Schnittstelle, verbundenen Bedienmodul für das Gerät angeordnet ist, insbesondere wobei ein berührungsempfindliches Bedienelement am Gerät und/oder am Bedienmodul angeordnet ist.

Die Aufgabe der Erfindung wird ferner gelöst durch ein Verfahren nach dem hierauf gerichteten, unabhängigen Anspruch 12. Dieses Verfahren dient dem Betrieb eines elektronischen Labor- und Prüfgeräts, insbesondere für ein Elektroniklabor, insbesondere nach vorstehend beschriebener Art, oder eines Systems nach vorstehend beschriebener Art, wobei eine Geste einer Hand eines Bedieners des Geräts berührungslos erfasst wird und wobei das Gerät anhand der Geste gesteuert wird.

Die Erfindung wird nachfolgend lediglich beispielhaft anhand der schematischen Zeichnungen erläutert.
- Fig. 1: zeigt ein beispielhaftes Labor- und Prüfgerät in einer Frontansicht.
- Fig. 2: zeigt das Labor- und Prüfgerät aus Fig. 1 in einer Schnittansicht entlang der Linie A-A.
- Fig. 3: zeigt eine perspektivische Ansicht des Inneren eines Labor- und Prüfgeräts.
- Fig. 4: zeigt eine Fronteinheit eines Labor- und Prüfgeräts.
- Fig. 5: zeigt eine Frontansicht eines Labor- und Prüfgeräts.
- Fig. 6: zeigt eine perspektivische Explosionsansicht eines Labor- und Prüfgeräts.
- Fig. 7: zeigt eine weitere Explosionsdarstellung des Geräts der Fig. 6.
- Fig. 8: zeigt ein weiteres beispielhaftes Labor- und Prüfgerät in einer Frontansicht.
- Fig. 9: zeigt eine Frontplatte des Labor- und Prüfgeräts der Fig. 7 in einer Schnittansicht entlang der Linie B-B.
- Fig. 10: zeigt ein Labor- und Prüfgerätesystem mit einem separaten Bedienmodul.
- Fig. 11: illustriert verschiedene berührungslose Gesten zur Steuerung eines Labor- und Prüfgeräts.
- Fig. 12: zeigt ein weiteres beispielhaftes Labor- und Prüfgerät in einer Frontansicht.

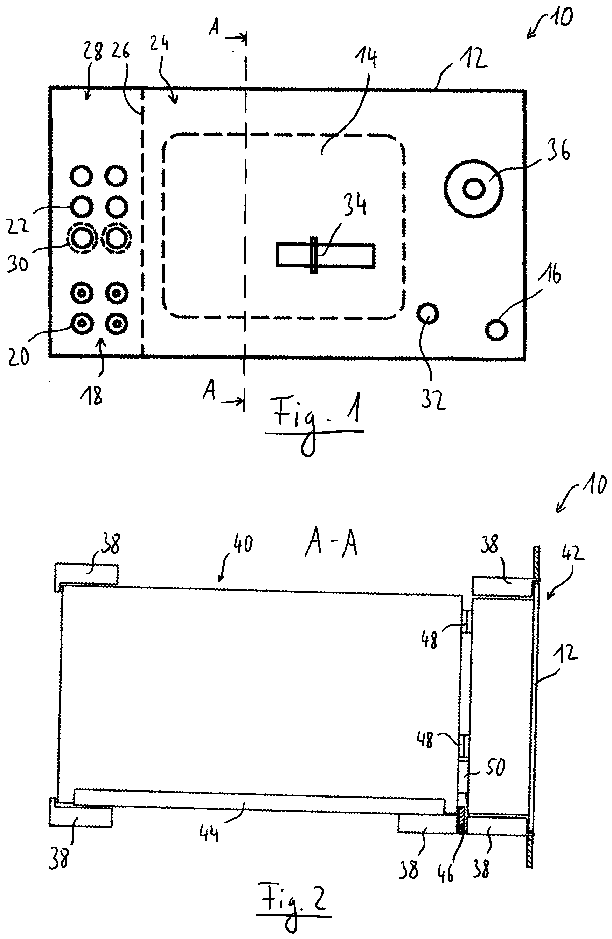

Fig. 1 zeigt ein Labor- und Prüfgerät 10, nachfolgend abkürzend "Gerät", mit einer Frontplatte 12 und einem daran angeordneten Bildschirm 14. Das Gerät 10 enthält elektronische Komponenten und Baugruppen. Beispielsweise kann das Laborund Prüfgerät 10 ein DC-Netzteil, AC-Netzteil, Arbiträrgenerator, Datenlogger, Multimeter, Funktionsgenerator, Leistungsmesser, Hochspannungsprüfgerät, Isolationsprüfgerät, Schutzleiterprüfgerät, Ableitstromprüfgerät und/oder Funktionsprüfgerät umfassen. Es ist zum Beispiel möglich, zwei Multimeter vorzusehen, um durch eine Bestimmung der Spannung und der Stromstärke direkt eine von einem zu prüfenden Gerät aufgenommene elektrische Leistung zu messen. Alternativ oder zusätzlich kann zum Beispiel ein Multimeter und ein Netzteil im Gerät 10 vorgesehen sein, wobei ein Einschaltstrom eines Elektrogeräts gemessen werden kann, indem das Netzteil mit dem Elektrogerät verbunden und eingeschaltet wird und der Strom mit dem Multimeter, insbesondere mit hoher zeitlicher Auflösung, gemessen wird. Das Netzteil ist insbesondere ein Regelnetzteil und dient als Gleichspannungs-/Gleichstromquelle und/oder Wechselspannungs/Wechselstromquelle, also als DC- und/oder AC-Netzteil.

Das Gerät 10 umfasst einen Ein/Aus-Schalter 16, mit dem das Gerät 10 in Betrieb genommen werden kann. Ferner weist das Gerät 10 eine Reihe von Anschlüssen 18 auf, mit denen das Gerät 10 mit zu prüfenden oder zu testenden Komponenten verbunden werden kann. Das Gerät 10 kann über die Anschlüsse 18 z.B. Eingangssignale empfangen und/oder mit Hilfe von Ausgangssignalen auf andere, externe elektronische Komponenten wirken. Z.B. können als Anschlüsse 18 wenigstens eine BNC-Buchse 20 und/oder wenigstens eine Buchse 22 für sogenannte "Bananenstecker" vorgesehen. In diesem Beispiel sind vier BNC-Buchsen 20 und sechs Buchsen 22 vorgesehen. Es versteht sich, dass Art, Anzahl und/oder Anordnung der Anschlüsse 18 je nach Bedarf variieren können. Bevorzugt können zwei bis acht Buchsen 22 vorgesehen sein. Bei acht Buchsen 22 können z.B. zwei Buchsen 22 für ein erstes Netzteil, zwei Buchsen 22 für ein zweites Netzteil und vier Buchsen 22 für ein Multimeter vorgesehen sein. Dies erlaubt eine besondere große Flexibilität in der Verwendung des Geräts 10 ohne Zusatzmodule.

Zur Steuerung des Geräts 10 ist ein Bedienfeld 24 vorgesehen, das hier einen Teil der Frontplatte 12 ausmacht. Das Bedienfeld 24 ist berührungsempfindlich ausgebildet, zum Beispiel mittels eines kapazitiven Funktionsprinzips. Eine Linie 26 kennzeichnet eine Grenze zwischen dem Bedienfeld 24 und einem Anschlussfeld 28, welches zwar grundsätzlich auch berührungsempfindlich ausgebildet sein kann, jedoch bevorzugt nicht berührungsempfindlich ausgebildet ist.

Die Frontplatte 12 bildet bevorzugt die einem Benutzer zugewandte Seite des Geräts 10. Sie kann je nach Bedarf und Einsatzumgebung aus verschiedenen Materialien hergestellt sein, bevorzugt aus einem Material, welches ein Dielektrikum bildet, d.h. ein Material, welches nichtleitend oder schwachleitend ist. Bevorzugt ist die Fronplatte aus Glas hergestellt, kann z.B. aber auch aus Kunststoff, insbesondere PMMA, hergestellt sein. Besonders bevorzugt ist eine Frontplatte 12 aus gehärtetem Glas und/oder Sicherheitsglas, insbesondere als Einscheiben-Sicherheitsglas, ausgebildet. Die Frontplatte 12, insbesondere eine aus Glas hergestellte Frontplatte, kann bevorzugt eine Dicke von wenigstens 2 mm und/oder bevorzugt höchstens 4 mm, insbesondere etwa 3 mm, aufweisen. Allgemein bevorzugt kann eine Frontplatte 12 als eine einzige und/oder durchgehende Glasplatte wenigstens im Anschlussfeld 28 und vor dem Bildschirm 14 ausgebildet sein. Ferner kann die Frontplatte 12 durch einen hier nicht dargestellten Rahmen eingefasst sein, falls dies erwünscht oder erforderlich ist.

Das Bedienfeld 24 kann verschiedene Abschnitte aufweisen, die zur Steuerung des Geräts 10 dienen. Beispielsweise können Abschnitte des Bedienfeldes 24 bei Berührung wie Schalter, Knöpfe, Schiebe- und/oder Drehregler oder allgemein als Bedienelemente wirken, mit denen zwischen verschiedenen Funktionalitäten des Geräts 10 gewechselt werden kann und/oder für verschiedene Funktionalitäten eine Einstellung vorgenommen werden kann, beispielsweise ein Wert eingestellt werden kann.

Um die Montage der Frontplatte 12 zu vereinfachen, kann diese z.B. mittels eines Rastmechanismus oder mittels einer magnetischen Befestigungseinrichtung an einem Gehäusebauteil des Geräts 10 oder einem Rahmen eines Einschubsystems befestigbar sein. Die Frontplatte 12 wird dabei bevorzugt lediglich an der vorgesehenen Stelle eingesetzt, bis der Rastmechanismus einschnappt oder die von der Befestigungseinrichtung erzeugten magnetischen Kräfte stark genug sind, um die Frontplatte 12 sicher zu fixieren. Daher ist eine weitgehend werkzeugfreie Montage der Frontplatte 12 möglich. An der Frontplatte 12, insbesondere an deren dem Betrachter von Fig. 1 abgewandten Seite, können weitere Komponenten befestigt sein, die mit der Frontplatte 12 am Gehäusebauteil bzw. am Rahmen befestigt werden, so zum Beispiel ein Bildschirm 14 und/oder eine Steuereinheit für den Bildschirm und/oder für Funktionsmodule des Geräts 10. Zur Demontage der Frontplatte 12 kann zum Beispiel eine Saugvorrichtung vorgesehen sein, die an der Frontplatte 12 temporär befestigbar ist und mit der die Frontplatte 12 wieder entfernt werden kann.

Die Funktion des Geräts 10 kann mit Hilfe des Bildschirms 14 überwacht und gesteuert werden. Der Bildschirm 14 kann beispielsweise dazu eingerichtet sein, einen Betriebszustand und/oder aufgenommene Mess- oder Prüfwerte anzuzeigen. Die Bauart des Bildschirms 14 ist grundsätzlich beliebig und kann an die jeweils vorliegenden Anforderungen angepasst sein.

Um die Bedienung des Geräts 10 zu erleichtern, kann wenigstens ein Anschluss, insbesondere die Buchsen 20 und/oder 22, ein ihm zugeordnetes Leuchtelement 30, aufweisen, welches beispielsweise als LED-Einheit und/oder ringförmig ausgebildet sein kann. Insbesondere kann das Leuchtelement 30 die betreffende Buchse 20, 22 umschließen, z.B. wie in Fig. 1 in Form eines Kreisrings. Aus Gründen der Klarheit sind ringförmige Leuchtelemente 30 nur bei zwei Buchsen 22 gestrichelt angedeutet. Die in Abhängigkeit von einem gewählten Betriebszustand aktiven Buchsen 20, 22 können durch Aktivierung der entsprechenden Leuchtelemente 30 markiert werden, sodass der Benutzer sofort weiß, wo er welche Kabel anzuschließen hat. Diese Markierung kann durch einen Verschwindeeffekt optisch noch ansprechender gestaltet werden. Ein Verschwindeeffekt zeichnet sich dadurch aus, dass das Leuchtelement im inaktiven Leuchtzustand zumindest im Wesentlichen nicht sichtbar ist und/oder nur dann sichtbar ist, wenn das Leuchtelement leuchtet. Die Bezeichnung bezieht sich also darauf, dass das Leuchtelement beim Übergang in den inaktiven Leuchtzustand aus Sicht eines Betrachters "verschwindet". Dies kann z.B. durch eine entsprechende Einfärbung oder Beschichtung der Frontplatte erreicht werden, so dass diese zumindest im Bereich des Leuchtelements transluzent ausgebildet ist.

Die Leuchtelemente 30 umfassen beispielsweise jeweils vier in Umfangsrichtung gleichmäßig verteilte LEDs. Das Licht der LEDs wird beispielsweise durch einen Diffusor verteilt, so dass der Benutzer einen im Wesentlichen gleichmäßig ausgeleuchteten Ring wahrnimmt, wenn die entsprechenden LEDs aktiviert sind. Eine Hülse zwischen der entsprechenden Buchse 20, 22 und den ihr zugeordneten LEDs schirmt unerwünschtes Streulicht zuverlässig ab.

Der Bildschirm 14 ist in das Gerät 10 integriert. Er kann beispielsweise ein Bildschirm herkömmlicher Bauart sein, der hinter der Frontplatte 12 angeordnet ist, die zumindest in dem gestrichelt umrahmten Bereich transparent ausgebildet sein kann. Die Frontplatte 12 umfasst das Bedienfeld 24 bevorzugt als integralen Bestandteil. Das Bedienfeld 24 umfasst bevorzugt den gesamten Bereich der Frontplatte 12 rechts der vertikalen Linie 26. Mit anderen Worten ist das Bedienfeld 24 ein berührungsempfindlicher Abschnitt der Frontplatte 12. Auch der transparente Bereich der Frontplatte 12 ist berührungsempfindlich ausgebildet, sodass ein berührungsempfindlicher Bildschirm 14 für das Gerät 10 realisiert ist. Grundsätzlich kann beispielsweise auch unabhängig von einem berührungsempfindlichen Bedienfeld ein berührungsempfindlicher Bildschirm 14 vorgesehen sein.

Da der Bildschirm 14 berührungsempfindlich ausgebildet ist, können dargestellte Felder als "virtuelle Schalter oder Regler" genutzt werden, um das Gerät 10 und z.B. auch angeschlossene, hier nicht dargestellte Nebengeräte zu bedienen. Beispielsweise sind Menüführungen vorgesehen, mit deren Hilfe die jeweils gewünschten Funktionen des Geräts 10 und/oder die einzelnen Nebengeräte ausgewählt und gesteuert werden können.

Das Bedienfeld 24 kann allgemein auch in anderen Bereichen als vor dem Bildschirm 14 berührungsempfindlich sein. Bevorzugt werden allerdings lediglich Berührungen in bestimmten Bereichen des Bedienfeldes 24 als Bedieneingaben aufgefasst, nämlich bevorzugt lediglich vor dem Bildschirm und an ein oder mehreren, vom Bildschirm separaten Bedienelementen. Ein Bereich der Frontplatte 12 bzw. des Bedienfeldes 24, hier in der rechten unteren Ecke der Frontplatte 12, ist als Ein/Aus-Schalter 16 vorgesehen. Ein weiterer markierter Bereich 32 dient z.B. als weiterer Schalter, beispielsweise als Menü-Taste zur Einblendung eines Menüs.

Allgemein können also durch ein berührungsempfindliches Bedienfeld 24 ein oder mehrere Bedienelemente für das Gerät 10 bereitgestellt werden. Weiter allgemein können an der Frontplatte 12 ein oder mehrere berührungsempfindliche Bedienelemente vorgesehen sein.

Ein Bedienelement kann zum Beispiel alternativ oder zusätzlich auf einem Bildschirm 14 angezeigt sein. In Fig. 1 ist beispielsweise ein Bedienelement 34 auf dem Bildschirm 14 angezeigt, welches einen virtuellen Schieberegler bildet. Alternativ oder zusätzlich kann ein Bedienelement zum Beispiel auf einer bildschirmfreien Fläche, insbesondere neben einem Bildschirm 14 angeordnet sein. Die Bedienelemente bzw. Schalter 16 und 32 sind zum Beispiel auf einer bildschirmfreien Fläche angeordnet. Ein weiteres, ringförmiges Bedienelement 36 ist neben dem Bildschirm 14 angeordnet. Dieses bildet bevorzugt einen virtuellen Drehregler.

Ein Bedienelement, insbesondere ein solches, welches auf einer bildschirmfreien Fläche angeordnet ist, umfasst mit Vorteil eine Führungshilfe. Diese kann durch eine Gestaltung einer Fläche, an der es angeordnet ist, gebildet sein, wobei diese Gestaltung insbesondere von einer Gestaltung der restlichen Fläche abweicht. So kann die Führungshilfe z.B. zumindest eine Vertiefung, bevorzugt eine ringförmige Rille, umfassen. Alternativ oder zusätzlich kann die Führungshilfe zum Beispiel eine Erhebung, zum Beispiel eine Wulst, umfassen. Zum Beispiel kann eine Führungshilfe auch durch eine aufgeraute und/oder anderweitig strukturierte Fläche gebildet sein. Eine Führungshilfe kann beispielsweise gerade, teilringförmig oder ringförmig sein.

Allgemein kann ein Bedienelement einen vorbestimmten Bewegungsweg für den Finger eines Bedieners zum graduellen Einstellen einer Funktion des Geräts aufweisen, wobei der Bewegungsweg z.B. gerade, teilkreisförmig oder kreisförmig sein kann. Der Bewegungsweg kann beispielsweise durch eine Führungshilfe vorgegeben sein, so bevorzugt am Bedienelement 36, oder aber lediglich am Bedienelement sichtbar gekennzeichnet sein. Eine sichtbare Kennzeichnung kann beispielsweise an einem Bildschirm angezeigt sein, wie z.B. beim Bedienelement 34, oder, insbesondere wenn das Bedienelement nicht auf einem Bildschirm angeordnet ist, dauerhaft eingezeichnet sein.

Das Bedienelement 36 umfasst bevorzugt eine ringförmige Rille und übernimmt die Funktion eines Drehschalters oder -reglers. Ein Benutzer fährt mit seinem Finger entlang der Rille, um beispielsweise bestimmte Funktionsparameter, zum Beispiel eine Spannung eines Netzteils, einzustellen und/oder um sich innerhalb eines Bedienmenüs zu orientieren. Die Rille ist eine Vertiefung, die insbesondere in die Frontplatte eingefräst sein kann. Bei einer Berührung des Bedienfelds 24 in diesem Bereich spürt der Benutzer die Rille des Bedienelements 36. Sie führt die Bewegung des Fingers auf intuitive Weise auf einer kreisförmigen Bahn, bildet also eine Führungshilfe. Die Rille stellt neben einer optionalen optischen Orientierung, die z.B. durch eine herkömmliche Oberflächenmarkierung erreicht wird, auch eine haptische Orientierung dar, die die Bedienung des Geräts 10 vereinfacht. Zusätzlich oder alternativ kann die Oberfläche im Bereich der Rille des Bedienelements 36 aufgeraut sein. Außerdem kann die das Bedienelement 36, wie auch die Bedienelemente 16, 32, von einem Beleuchtungselement hinterlegt sein, um einen Betriebszustand oder eine "Stellung" des jeweiligen Bedienelements 16, 32, 36 anzuzeigen. Nachdem vorstehend lediglich berührungsempfindliche Bedienelemente beschrieben worden, versteht es sich, dass das Gerät 10 alternativ oder zusätzlich auch herkömmliche Bedienelemente, wie zum Beispiel Schalter und/oder Potentiometer, zur Bedienung des Geräts aufweisen kann.

Ein Bedienelement für das Gerät 10 kann beispielsweise alternativ oder zusätzlich auch an einem vom Gerät 10 separaten Bedienmodul angeordnet sein. Ein solches Bedienelement kann z.B. nach Art des Bedienelements 36 oder auch als konventioneller Dreh- oder Schieberegler ausgebildet sein.

Durch die Integration des Bedienfelds 24 in die Frontplatte 12 und die Anordnung des Bildschirms 14 hinter einem transparenten Bereich der Frontplatte 12 wird eine besonders kompakte Bauweise des Geräts 10 erreicht. Wenn die berührungsempfindlichen Bedienelemente 16, 32 und 36 sowie auf dem Bildschirm 14 dargestellte Bedienelemente, wie das Bedienelement 34, die genannten, herkömmlichen Bedienelemente mechanischer Bauart ersetzen, ist die Fehleranfälligkeit des Geräts 10 besonders gering. Mit herkömmlichen Bedienelementen einhergehende Fugen und Schlitze entfallen ebenfalls, so dass wenig Schmutz in das Gerät 10 eindringt. Außerdem kann die Frontplatte 12 aus dem jeweils geeigneten Material, insbesondere Glas, mit einer geeigneten Materialstärke gefertigt sein, um die jeweils erforderliche Robustheit bereitstellen zu können. Neben diesen praktischen Vorteilen hinsichtlich Robustheit und Kompaktheit verleiht die im Wesentlichen planare Ausgestaltung der Front des Geräts 10 diesem eine besonders übersichtliche Gestaltung. Außerdem lässt sich die Gerätefront leicht reinigen.

Fig. 2 zeigt das Labor- und Prüfgerät 10 aus Fig. 1 in einer Schnittansicht entlang der Linie A-A. Das Gerät 10 ist in ein Labormöbel, beispielsweise in eine Cockpitleiste eines Arbeits- oder Unterrichtsplatzes integriert. Das Labormöbel weist zu diesem Zweck Profilelemente 38 auf, die eine das Gerät 10 aufnehmende, rahmenförmige Struktur bilden. Das Gerät 10 wird in diese Struktur eingeschoben, so dass nur noch die Frontseite bzw. Frontplatte 12 des Geräts 10 sichtbar ist. Das Gerät 10 ist insbesondere kompatibel mit der 19"-Einschubtechnik, die bei vielen Laborgeräten zum Einsatz gelangt. Alternativ zur Integration in ein Labormöbel kann das Gerät 10 auch ein eigenes Gehäuse aufweisen und als "Standalone"-Gerät ausgebildet sein.

Das Gerät 10 umfasst einen Grundkörper 40, welcher beispielsweise mehrere Funktionsmodule enthält, und eine abnehmbare Fronteinheit 42. Der Grundkörper 40 bildet eine "Kassette", die von Schienen 44 (in Fig. 2 ist nur ein davon sichtbar) mit L-förmigem Querschnitt getragen wird. Die Schienen 44 gestatten ein Einschieben des Grundkörpers 40. In einem vollständig eingeschobenen Zustand schlägt der Grundkörper 40 an Absätzen der hinteren Profilelemente 38 an. Um den Grundkörper 40 in dieser Lage zu sichern, ist ein Sicherungsstück 46 vorgesehen.

Nach der Montage des Grundkörpers 40 wird die Fronteinheit 42 aufgesetzt. Sie wird in dieser Lage z.B. durch Magneten 48 gehalten, die an der Rückseite der Fronteinheit 42 und/oder an der Vorderseite des Grundkörpers 40 vorgesehen sind. Es versteht sich, dass die Magneten 48 auch nur an einer der beiden genannten Komponenten vorgesehen sein können, wenn die andere Komponente eine magnetisierbare Oberfläche aufweist. Zur zusätzlichen Sicherung der Fronteinheit 42 ist ein nicht gezeigter Verriegelungsmechanismus vorgesehen, mit dem die Fronteinheit 42 an dem Labormöbel - etwa an den vorderen Profilelementen 38 - und/oder an dem Grundkörper 40 gesichert werden kann. Allgemein kann die Fronteinheit 42 und/oder die Frontplatte 12 beispielsweise auch direkt und/oder lediglich an den vorderen Profilelementen 38 befestigt sein, beispielsweise durch Magneten und/oder eine Rasteinrichtung.

Die Übermittlung von Daten zwischen der Fronteinheit 42 und dem Grundkörper 40 wird durch eine Schnittstelle 50 gewährleistet, die beispielsweis eine Steckverbindung umfasst.

Fig. 2 macht deutlich, dass der Grundkörper 40 in Einbaulage nicht manipulierbar ist, da die Fronteinheit 42 seine Vorderseite insbesondere komplett überdeckt. Die Fronteinheit 42 wiederum weist eine planare Vorderseite auf, die z.B. bündig mit einer Verkleidung 52 des Labormöbels abschließt. Mit anderen Worten ist der Grundkörper 40 insbesondere nur bei abgenommener Fronteinheit 42 zugänglich. Das Gewicht des Grundkörpers 40 wird in der Einbaulage vollständig von den entsprechenden Profilelementen 38 aufgenommen, so dass der Fronteinheit 42 insbesondere keine tragende Funktion zukommt. Daher müssen zur Befestigung des Geräts 10 auch keine Schrauben vorgesehen sein, die die Fronteinheit 42 von vorn durchstoßen, wie es bei vielen bekannten Einschubsystemen der Fall ist. Da die Fronteinheit 42 keine zum Herausziehen geeigneten hervorstehenden Komponenten aufweist, ist zu ihrer Entnahme eine Griffvorrichtung mit Saugnäpfen vorgesehen, die an der im Wesentlichen glatten Vorderseite der Fronteinheit 42 bzw. der Frontplatte 12 befestigbar ist.

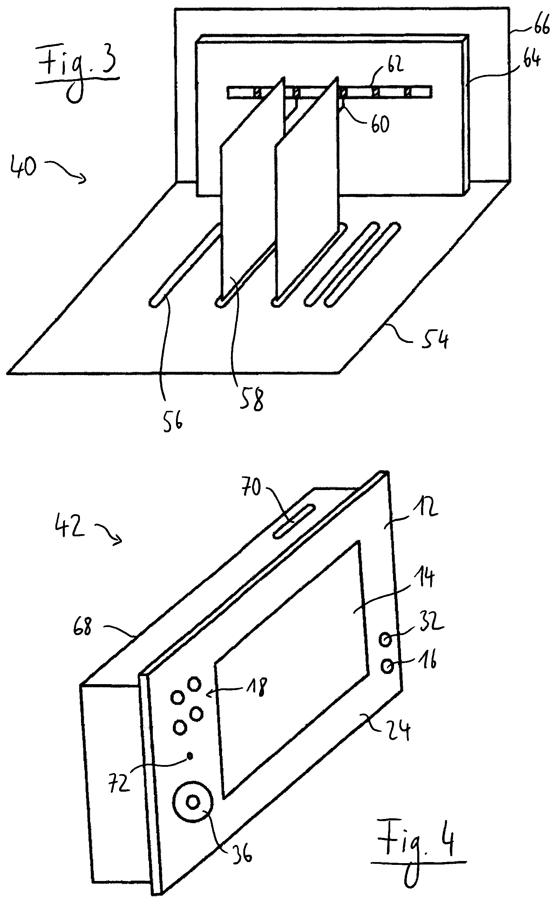

Fig. 3 zeigt den Innenaufbau eines Grundkörpers 40 eines Labor- und Prüfgeräts, beispielsweise desjenigen der Fig. 1 und/oder 2, wobei auf die Darstellung struktureller Elemente - wie z.B. eines Rahmens - aus Gründen der Übersichtlichkeit verzichtet wurde. Der Grundkörper 40 weist eine Grundplatte 54 auf, an der Befestigungssockel 56 zur Befestigung von Modulen, insbesondere Funktionsmodulen 58, vorgesehen sind. Die Funktionsmodule 58 können auch direkt an die Grundplatte 54 angeschraubt sein.

Die Funktionsmodule 58 sind hier in Form von Steckkarten ausgebildet, die in die Befestigungssockel eingesteckt sind. Grundsätzlich können auch weitere Funktionsmodule vorgesehen sein, die nicht in Form von Steckkarten ausgebildet sind. Beispielsweise kann ein AC-Netzteil in einem separaten Einschub angeordnet sein und/oder ein Multimeter kann hinter den Buchsen 20, 22 angeordnet sein. In beiden Fällen kann aber die Kommunikation ebenfalls über den Bus 62 erfolgen. Als Steckkarten entsprechend der Darstellung der Fig. 3 können insbesondere ein oder zwei DC-Netzteile, ein Multimeter und/oder ein Funktionsgenerator vorgesehen sein.

Die Funktionsmodule 58 stellen jeweils eine bestimmte Funktion bereit. Die Funktionsmodule 58 können beispielsweise jeweils z.B. ein DC-Netzteil, AC-Netzteil, Arbiträrgenerator, Datenlogger, Multimeter, Funktionsgenerator, Leistungsmesser, Hochspannungsprüfgerät, Isolationsprüfgerät, Schutzleiterprüfgerät, Ableitstromprüfgerät und/oder Funktionsprüfgerät sein. Mit anderen Worten kann das Gerät 10 durch eine geeignete Kombination von Funktionsmodulen 58 individuell an die Kundenbedürfnisse angepasst wer-den, ohne dass aufwändige konstruktive Änderungen des Geräts 10 erforderlich sind. Dabei können insbesondere auch zwei oder mehr Funktionsmodule 58 derselben Art vorgesehen werden, also z.B. zwei Netzteile und/oder zwei Multimeter.

Die Funktionsmodule 58 sind über Schnittstellen 60 mit einem Bus 62 verbunden, der an einer im Frontbereich des Grundkörpers 40 angeordneten Platine 64 vorgesehen ist. Die in Fig. 2 sichtbare Schnittstelle 50 wird in Fig. 3 durch die Platine 64 verdeckt. Vorderseitig wird der Grundkörper 40 durch eine Deckplatte 66 abgeschlossen, an der die Fronteinheit 42 mittels der Magnete 48 befestigt werden kann.

Es versteht sich, dass an der Grundplatte 54 und/oder der Platine 64 weitere elektronische und elektrische Komponenten, Leistungsbauteile, Stecker, Schnittstellen, Netzwerkadapter oder ähnliches vorgesehen sein können.

Fig. 4 zeigt eine perspektivische Ansicht einer Fronteinheit 42 mit einer Frontplatte 12, die bevorzugt aus Glas hergestellt ist, und einem Körper 68, der beispielsweise zumindest eine Steuereinheit zum Steuern des Bildschirms 14 und/oder des Bedienfelds 24 sowie eine fronteinheitsseitige Komponente der Schnittstelle 50 umfasst. Diese Komponente ist aufgrund der gewählten Perspektive in Fig. 4 nicht sichtbar. Die Steuereinheit - oder eine zusätzliche, separate Steuereinheit - kann auch zur Steuerung der Funktionsmodule 58 dienen. Damit enthält der Körper 68 bevorzugt den "Kern" oder das "Steuerzentrum" des Geräts 10, das mittels einer individualisierten Wahl der Funktionsmodule 58 an die Kundenwünsche angepasst werden kann.

Ein berührungsempfindliches Bedienfeld 24 überdeckt hier ein Bedienelement 36, welches beispielsweise einen Drehschalter simuliert, und den Bildschirm 14. Beispielsweise können so auf dem Bildschirm 14 angezeigte Objekte ausgewählt und durch Wischbewegungen verschoben werden. Das Bedienfeld 24 ist bevorzugt zumindest im Bereich des Bildschirms 14 multitouch-tauglich. Bevorzugt ist das Gerät 10 auch mittels Berührungsgestensteuerung steuerbar. In Fig. 4 sind zwei weitere Bedienelemente dargestellt, die beispielsweise den Bedienelementen 16 und 32 entsprechen können.

An der Oberseite des Körpers 68 ist ein Einschub 70 angeordnet, der ein Speichermedium aufnimmt. So können auf das Gerät 10 beispielsweise neue oder kundenspezifische Softwaremodule aufgespielt werden. Es ist z.B. auch möglich, gemessene Daten, Nutzungsdaten oder Fehlerprotokolle auf dem Speichermedium zu hinterlegen, um diese später extern auswerten zu können. Auch Ressourcen-Dateien, beispielsweise unterschiedliche Sprachdateien für die Darstellung der Menüführung des Geräts oder entsprechender Hilfeseiten in unterschiedlichen Sprachen, können auf dem Speichermedium hinterlegt sein. Alternativ oder zusätzlich kann z.B. eine hier nicht dargestellte Schnittstelle - z.B. ein USB-Steckplatz - vorgesehen sein, um die Fronteinheit 42 an ein externes Gerät - etwa eine Diagnoseeinheit - anschließen zu können.

Die Lage des Einschubs 70 stellt sicher, dass dieser nicht von unbefugten Personen genutzt werden kann, da dazu bevorzugt die Fronteinheit 42 abgenommen werden muss. Dies ist aber insbesondere nur dann möglich, wenn der vorstehend bereits erwähnte Verriegelungsmechanismus entriegelt wird. Dieser ist insbesondere nur durch ein kleines Loch 72 von vorne zugänglich und betätigbar, so dass zu seiner Betätigung ein Spezialwerkzeug erforderlich ist, das nur befugten Personen zur Verfügung steht.

Grundsätzlich und alternativ oder zusätzlich zum Einschub 70 kann das Gerät 10 beispielsweise auch eine Kommunikationsschnittstelle, wie beispielsweise eine RJ45-Schnittstelle und/oder eine USB-Schnittstelle, aufweisen, insbesondere zur Einspielung von Updates. Das Gerät 10 kann beispielsweise auch eine Netzwerkschnittstelle aufweisen, beispielsweise zum Anschluss an einen Internetzugang.

Das Gerät 10 kann beispielsweise verschiedene Sprachen für eine am Bildschirm 14 angezeigte Anzeige- und Steueroberfläche vorsehen. Diese können beispielsweise im Betriebssystem des Geräts 10 hinterlegt sein oder auch über eine Kommunikationsschnittstelle, insbesondere über das Internet, nachgeladen werden.

Die Anzahl, Anordnung, Ausgestaltung und Auswahl von Anschlüssen 18, z.B. oben beschriebene Buchsen 20, 22, kann frei gewählt werden. Gleiches gilt für die Ausgestaltung und Anordnung der durch das Bedienfeld 24 bereitgestellten Bedienelemente und der ggf. vorgesehenen Beleuchtungselemente zur Bedienungsführung und/oder Statusanzeige.

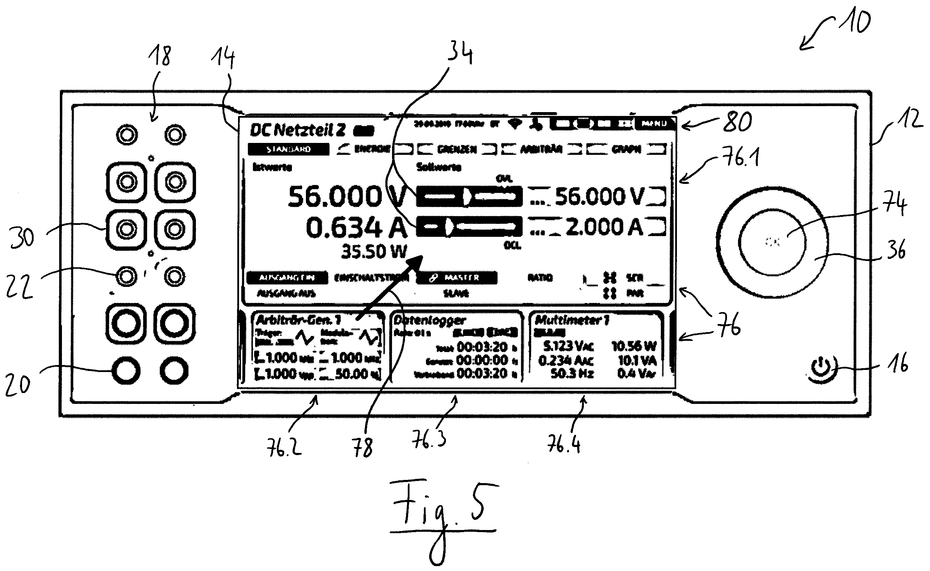

Fig. 5 zeigt eine Frontansicht bzw. eine Frontplatte 12 eines Labor- und Prüfgeräts 10. Es ist ein Bildschirm 14 sichtbar, auf dem eine Anzeige- und Steueroberfläche - bzw. kurz "Oberfläche" - bereitgestellt ist. Neben dem Bildschirm 14 ist ein Bedienelement 36 vorgesehen, welches beispielsweise entsprechend dem oben beschriebenen Bedienelement 36 ausgebildet sein kann, insbesondere einen virtuellen Drehregler bilden kann. Bevorzugt kann innerhalb der ringförmigen Führungshilfe des Bedienelements 36 ein weiteres Bedienelement 74 vorgesehen sein, mittels dessen zum Beispiel eine durch das Bedienelement 36 getroffene Auswahl bestätigbar sein kann. Ferner ist ein Ein/Aus-Schalter 16 vorgesehen. Ein Bedienelement entsprechend dem Bedienelement 32 ist diesem Beispiel nicht vorgesehen. Der Bildschirm 14 sowie die Bedienelemente 16, 36 und 74 sind bevorzugt allesamt berührungsempfindlich ausgebildet. Es können aber z.B. auch konventionelle Schalter und Schiebe- und/oder Drehregler vorgesehen sein, beispielsweise auch an einem separaten Bedienmodul.

Das Gerät 10 der Fig. 5 umfasst außerdem mehrere Anschlüsse 18, zum Beispiel BNC-Buchsen 20 und/oder Buchsen 22 für Bananenstecker. Für die Anschlüsse 18 bzw. Buchsen 20, 22 sind zugeordnete Leuchtelemente 30 vorgesehen. Entsprechend den obigen Ausführungen ist also insbesondere eine Buchsenbeleuchtung zur Indikation eines Status und/oder einer Funktion der betreffenden Buchsen vorgesehen. Die Leuchtelemente 30 umschließen die betreffenden Buchsen 20, 22. Ihre Form ist hier - im Gegensatz zur Kreisringform der Leuchtelemente 30 der Fig. 1 - beispielhaft durch ein Quadrat mit abgerundeten Ecken gebildet.

Wie vorstehend beschrieben, kann das Gerät 10 mehrere Funktionsmodule 58 umfassen, die jeweils unterschiedliche Funktionalitäten bereitstellen. Beispielsweise umfasst das Gerät 10 der Fig. 5 wenigstens ein DC-Netzteil, einen Arbiträrgenerator, einen Datenlogger und ein Multimeter sowie bevorzugt weitere Funktionsmodule 58.

Die auf dem Bildschirm 14 der Fig. 5 bereitgestellte Oberfläche weist mehrere Modulbereiche 76 auf, welche unterschiedlichen Funktionsmodulen 58 zugeordnet und/oder zuordenbar sind. In der hier dargestellten Ansicht, welche bevorzugt eine von mehreren auswählbaren Ansichten ist, sind vier Modulbereiche 76 vorgesehen, nämlich ein Primärmodulbereich 76.1 sowie drei Sekundärmodulbereiche 76.2, 76.3 und 76.4.

In einem jeweiligen Modulbereich 76 ist ein Name des zugeordneten Funktionsmoduls 58 angezeigt, nämlich "DC Netzteil 2" im Modulbereich 76.1, "Arbiträr-Gen. 1" im Modulbereich 76.2, "Datenlogger" im Modulbereich 76.3 und "Multimeter 1" im Modulbereich 76.4. Alternativ oder zusätzlich können die Modulbereiche 76 unterschiedlich farblich hervorgehoben sein. Im jeweiligen Modulbereich 76 sind außerdem Informationen des zugeordneten Funktionsmoduls 58, beispielsweise Betriebsparameter und/oder Messdaten, angezeigt. Der Modulbereich 76.1 weist außerdem beispielsweise zwei Bedienelemente 34 auf, die bevorzugt entsprechend dem oben beschriebenen Bedienelement 34 als virtueller Schieberegler ausgebildet sein können. In dem hier dargestellten Beispiel lassen sich etwa die Spannung oder der Strom, welche vom "DC Netzteil 2" an den Anschlüssen 18, insbesondere den Buchsen 22, bereitgestellt werden, jeweils mittels eines der Bedienelemente 34 einstellen.

In den Sekundärmodulbereichen 76.2, 76.3, 76.4 werden die ihnen zugeordneten Funktionsmodule 58 mit einem reduzierten Informationsgehalt angezeigt. Um eines der Funktionsmodule 58, welche den Sekundärmodulbereichen zugeordnet sind, dem Primärmodulbereich 76.1 zuzuordnen, ist zum Beispiel eine Berührungsgeste implementiert, sodass der Bediener z.B. mit einer Wischbewegung das betreffende Funktionsmodul 58 in den Primärmodulbereich 76.1 "ziehen" kann. Diese Bewegung wird in Fig. 5 durch einen Pfeil 78 angedeutet. Das vorher dem Primärmodulbereich 76.1 zugeordnete Funktionsmodul 58 wird anschließend insbesondere in dem entsprechenden Sekundärmodulbereich 76.2 angezeigt. Die Funktionsmodule 58 werden also zwischen den Modulbereichen ausgetauscht.

Die Sekundärmodulbereiche 76.2, 76.3 und 76.4 sind in einer Reihe angeordnet und insbesondere mittels einer entsprechenden, horizontalen Wischbewegungen bewegbar, nämlich "durchscrollbar". Das Gerät 10 weist, wie erwähnt, bevorzugt weitere Funktionsmodule 58 auf, die mit zugeordneten Modulbereichen beim Scrollen an einem Ende der Reihe sichtbar werden bzw. am anderen Ende verschwinden. Dabei bildet die Reihe von Sekundärmodulbereichen insbesondere eine verschiebliche Palette von Funktionsmodulen 58 zur wahlweisen Zuordnung zum Primärmodulbereich 76.1.

Die auf dem Bildschirm 14 bereitgestellte Oberfläche umfasst außerdem einen Abschnitt 80. In dem Abschnitt 80 sind hier beispielhaft Informationen des Gesamtsystems, insbesondere Datum, Uhrzeit und/oder ein Netzwerkverbindungszustand, dargestellt. Ferner sind im Abschnitt 80 z.B. berührungsempfindliche Mittel zur Auswahl zwischen verschiedenen wählbaren Ansichten der Oberfläche dargestellt. Schließlich ist beispielhaft in der oberen rechten Ecke des Bildschirms 14 ein Menü-Button im Abschnitt 80 angezeigt, mit dem ein Menü ausklappbar ist.

Ein vom Bildschirm 14 separates Bedienelement, wie zum Beispiel ein Bedienelement 36, kann beispielsweise wahlweise den Modulbereichen 76 und/oder einzelnen Funktionen, Parametern und/oder Einstellungen der Funktionsmodule bzw. Modulbereiche 76 zuordenbar sein.

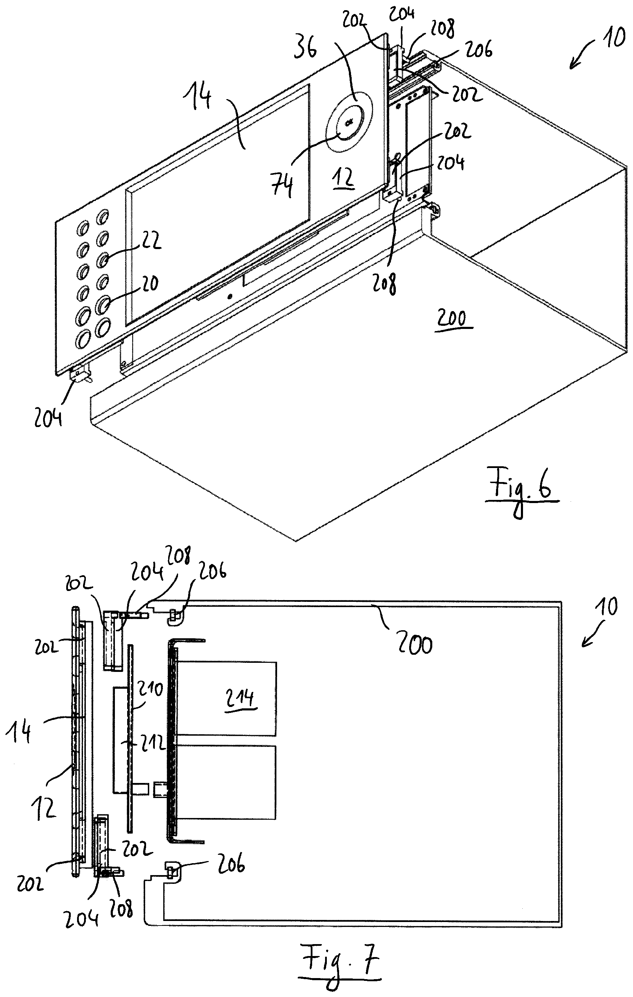

In den Fig. 6 und 7 ist ein Labor- und Prüfgerät 10 jeweils in Explosionsdarstellung mit ausgewählten Teilen dargestellt. Ausgewählte Bezugszeichen sind entsprechend den obigen Ausführungen vergeben. Was die Bezugszeichen 20 und 22 in Fig. 6 betrifft, so sind hier lediglich entsprechende Ausnehmungen in der Frontplatte 12 gezeigt aber im Zusammenbau entsprechende Buchsen vorgesehen.

Das Gerät 10 umfasst ein Gehäuse 200, an dem die Frontplatte 12 befestigt wird. An der Frontplatte 12 ist auch der Bildschirm 14 angeordnet. Bei dem Gehäuse 200 kann es sich beispielsweise um ein Gehäuse lediglich des Geräts 10 handeln - das Gerät bildet dann ein "Standalone"-Gerät - oder beispielsweise auch um ein längeres Profil, in welches das Gerät 10 neben anderen elektronischen Geräten und/oder Erweiterungs- und/oder Bedienmodulen für das Gerät 10 eingebaut werden kann.

Die Befestigung der Frontplatte 12 am Gehäuse 200 ist hier lösbar durch Magneten 202 ausgeführt, wobei Magneten 202 direkt auf der Frontplatte 12 aufgeklebt sind und mit Magneten 202 zum Halten der Frontplatte 12 zusammenwirken, welche am Gehäuse 200 befestigt sind. Konkret ist ein jeweiliger, gehäuseseitiger Magnet 202 in einer Magnethalterung 204 angeordnet, die an einem Gewindestreifen 206 über eine jeweilige Schraube 208 befestigt ist. Der Gewindestreifen 206 ist in einer Ausnehmung des Gehäuses 200 angeordnet. In der in Fig. 6 gewählten Perspektive sind lediglich drei Magnethalterungen 204 sowie von den frontplattenseitigen Magneten 202 lediglich zwei sichtbar.

Bei einer hier nicht dargestellten Ausführungsform sind zwei Magnethalterungen 204 miteinander fest verbunden. Insbesondere können die beiden an gleicher Horizontalposition vorgesehenen Magnethalterungen 204 miteinander verbunden sein, z.B. die in Fig. 6 am rechten Ende der Frontplatte 12 sichtbaren Magnethalterungen 204 und/oder die am linken Ende der Frontplatte 12 vorgesehenen Magnethalterungen 204, von den nur die untere in Fig. 6 sichtbar ist. Bevorzugt können die zwei Magnethalterungen 204 einteilig verbunden sein. Sie sind dann insbesondere als eine Art längliche Platte ausgebildet, die sich von dem oberen Gewindestreifen bis zu dem unteren Gewindestreifen zumindest im Wesentlichen vertikal erstreckt.

In Fig. 7 ist ferner eine Platine 210 sichtbar, die als sogenannte HAT-Platine ausgebildet ist und eine Steuerungseinheit 212 für den Bildschirm 14 trägt. Die Platine 210 ist außerdem mit weiteren Komponenten 214 und hierüber mit den in Fig. 7 nicht gezeigten Funktionsmodulen 58 verbunden.

Die hier beschriebenen Labor- und Prüfgeräte können an Arbeitsplätzen in Laboroder Unterrichtsräumen oder an sonstigen Mess- und Entwicklungsarbeitsplätzen sowie in Prüffeldern und/oder an Montagearbeitsplätzen zum Einsatz gelangen und - falls gewünscht - in Netzwerke eingebunden sein. Auch eine Verwendung als Testgeräte für elektrische Sicherheits- und Funktionsprüfungen, insbesondere für Hochspannungsprüfungen, Isolationsprüfungen, Schutzleiterprüfungen und/oder Ableitstromprüfung, ist ohne weiteres möglich.

Ferner können die Geräte Einschubgeräte sein, die für 19"-Einschubfächer geeignet sind. Es versteht sich jedoch, dass die Geräte grundsätzlich beliebig dimensioniert sein können, um den Kundenanforderungen gerecht zu werden. Da sich die Geräte sehr kompakt gestalten lassen, ist es auch möglich, sie direkt in geeignete Profilelemente oder Kanäle von Labormöbeln zu integrieren oder als kompaktes "Standalone"-Gerät auszubilden.

Der Vollständigkeit halber wird darauf hingewiesen, dass die einzelnen Funktionalitäten und konstruktiven Details, die lediglich in Zusammenhang mit bestimmten der beispielhaft beschriebenen Ausführungsformen des Labor- und Prüfgeräts erwähnt wurden, beliebig auch auf andere Ausführungsformen übertragbar sind, um den jeweils vorliegenden Kundenwünschen Rechnung tragen zu können.

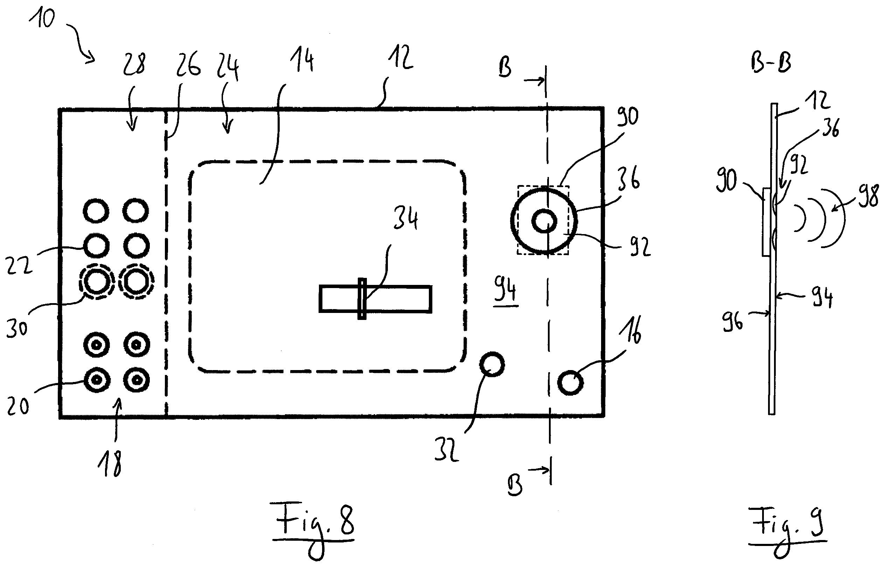

Das in Fig. 8 gezeigte Labor- und Prüfgerät 10 ist ähnlich wie dasjenige der Fig. 1 aufgebaut, weshalb die Bezugszeichen entsprechend vergeben sind und insoweit auf die obigen Ausführungen verwiesen wird. Zudem umfasst das Gerät 10 erfindungsgemäß einen Gestensensor 90. Der Gestensensor 90 ist hier lediglich gestrichelt angedeutet, weil er auf einer dem Betrachter von Fig. 8 bzw. im Betrieb dem Bediener abgewandten Seite der Frontplatte 12 angeordnet ist und folglich für den Bediener nicht sichtbar ist.

In Fig. 8 ist eine Schnittlinie B-B eingezeichnet, die durch den Gestensensor 90 und das Bedienelement 36 verläuft. Eine Schnittansicht mit Schnittebene entsprechend der Linie B-B ist in Fig. 9 dargestellt. Hier sind der Gestensensor 90 und vom Bedienelement 36 eine ringförmige Vertiefung 92 im Schnitt sichtbar. Die Vertiefung 92 bildet eine Führungshilfe des Bedienelements 36.

Das Bedienelement 36 ist auf einer ersten Seite 94 der Frontplatte 12, nämlich einer dem Bediener zugewandten Seite, angeordnet. Der Gestensensor 90 ist auf einer zweiten Seite 96 der Frontplatte 12, nämlich einer dem Bediener abgewandten Seite, angeordnet. In diesem Beispiel ist der Gestensensor 90 direkt gegenüberliegend zum Bedienelement 36 angeordnet. Alternativ könnte der Gestensensor 90 aber beispielsweise auch zum Bedienelement 36 versetzt, z.B. oberoder unterhalb desselben oder hinter dem Bildschirm 14, angeordnet sein. Grundsätzlich können auch mehrere Gestensensoren vorgesehen sein, beispielsweise einer - wie dargestellt - hinter dem Bedienelement 36 und einer hinter dem Bildschirm 14.

Der Gestensensor 90 ist dazu eingerichtet, ein elektrisches Feld 98 zu erzeugen, eine Veränderung des elektrischen Feldes 98 durch eine Hand eines Benutzers zu erkennen und in Abhängigkeit von der Veränderung eine berührungslose Geste zur Steuerung des Geräts 10 zu ermitteln.

Der Gestensensor 90 ist außerdem zur Erfassung einer Berührung des berührungsempfindlichen Bedienelements 36 zur Steuerung des Geräts 10 eingerichtet. Der Gestensensor 90 hat somit eine Doppelfunktion, nämlich sowohl die berührungslose Erfassung von Gesten als auch die Erfassung von Berührungen, insbesondere auch Berührungsgesten, des Bedienelements 36. Der Gestensensor 90 ist zu diesem Zweck derart angeordnet und eingerichtet, dass das Feld 98 aus einer Außenfläche des Geräts 10, nämlich aus der Frontplatte 12, heraussteht, um berührungslos Gesten im Bereich vor dem Bedienelement 36 zu ermitteln. Dabei wird mittels eines Feldbereiches, der nicht oder nur minimal aus der Außenfläche heraussteht, aber im Bereich der Außenfläche selbst aktiv ist, eine Berührung des Bedienelements 36 zur Steuerung des Geräts 10 festgestellt. Somit kann insbesondere mit ein und demselben Sensor 90 bzw. ein und demselben Feld 98 in Abhängigkeit vom Abstand der Hand zur Außenfläche des Bedienelements 36 sowohl eine berührungslose Geste als auch eine Berührung erfasst werden.

Die Frontplatte 12 ist bevorzugt aus Glas hergestellt, sodass sich das elektrische Feld 98 des Gestensensors 90 weitgehend ungehindert durch die Frontplatte 12 hindurch erstrecken kann.

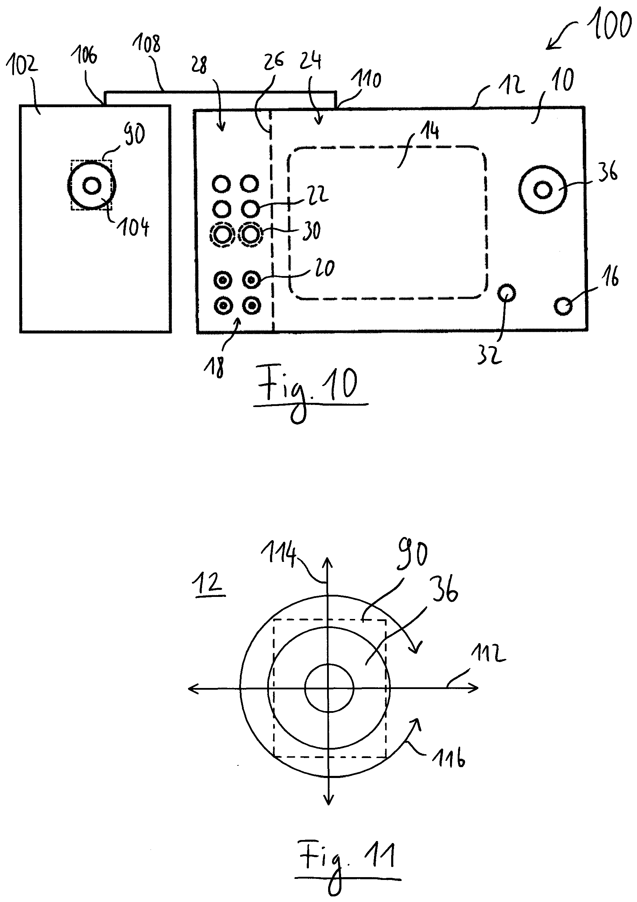

In Fig. 10 ist ein elektronisches Labor- und Prüfgerätesystem 100 gezeigt, welches ein elektronisches Labor- und Prüfgerät 10 und ein mit diesem zu dessen Steuerung verbundenes Bedienmodul 102 umfasst. Das Gerät 10 ist ähnlich demjenigen der Fig. 1 aufgebaut, wobei die Bezugszeichen entsprechend vergeben sind und insoweit auf die obigen Ausführungen verwiesen wird.

Das Bedienmodul 102 umfasst ein berührungsempfindliches Bedienelement 104 zur Steuerung der Funktionen des Geräts 10 bzw. der Funktionsmodule 58. Das Bedienelement 104 kann insbesondere entsprechend dem Bedienelement 36 der Geräte 10 der Fig. 1 bis 9 ausgebildet sein.

Das Bedienmodul 102 weist einen Anschluss 106 auf, der über eine Verbindungsleitung 108 mit einem Anschluss 110 des Geräts 10 verbunden ist. Insbesondere kann das Bedienelement 104 des Bedienmoduls 102 dabei an einen hier nicht näher dargestellten Bus des Geräts 10 angeschlossen sein, an den beispielsweise auch das Bedienelement 36 des Geräts 10 angeschlossen ist. Der Bus bildet insoweit bevorzugt einen gemeinsamen Bus, insbesondere einen Bedienbus.

Das Bedienmodul 102 umfasst ferner einen Gestensensor 90, der beispielsweise entsprechend dem Gestensensor 90 der Fig. 8 und 9 ausgebildet sein kann. Der Gestensensor 90 kann ebenfalls an den gemeinsamen Bus angeschlossen sein. Alternativ oder zusätzlich kann auch ein Gestensensor am Gerät 10 vorgesehen sein.

In Fig. 11 sind einige beispielhafte berührungslose Gesten zur Steuerung des Geräts 10 illustriert. Diese sind in Bezug auf einen Gestensensor 90 dargestellt, der hinter einem Bedienelement 36 bzw. einer Frontplatte 12 angeordnet ist, wie es zum Beispiel in den Figuren 8, 9 und 10 der Fall ist.

Es sind Translationsgesten 112 und 114 in zueinander senkrechten Dimensionen vorgesehen. Außerdem ist eine Kreisgeste 116 vorgesehen. Die Gesten 112, 114 und 116 sind mit Pfeilenden in entgegengesetzten Richtungen illustriert, um zu veranschaulichen, dass es sich jeweils um ein Paar von Gesten handelt, welche auf derselben Bahn verlaufen aber in ihrer Richtung entgegengesetzt sind. Dabei sind die Gesten 112, 114, 116 in ihren Steuerungsfunktionen ebenfalls einander entgegengesetzt. Mit Bezug auf die Kreisgeste 116 kann beispielsweise eine Bewegung der Hand im Uhrzeigersinn zu einer Erhöhung eines Parameters, beispielsweise einer Spannungsausgabe, führen, während eine Bewegung der Hand entgegen dem Uhrzeigersinn zu einer Verringerung des Parameters führen kann. Somit ist ein Drehregler "in der Luft" simuliert.

Die hier beispielhaft dargestellten Steuerungsgesten 112, 114 und 116 erfolgen allesamt in einer Ebene, die zur Erstreckungsebene der Frontplatte 12 parallel ist. Es können auch weitere oder andere Steuerungsgesten implementiert sein, beispielsweise solche, die eine Näherung und/oder eine Entfernung der Hand an die bzw. von der Frontplatte 12 umfassen.

Nachfolgend werden besonders vorteilhafte Zuordnungen von Gesten zu Steuerungsfunktionen beschrieben, die kombiniert oder auch unabhängig voneinander implementiert sein können. Die verschiedenen Steuerungsfunktionen für eine jeweilige Geste können insbesondere kontextabhängig gültig sein.
Geste:
   - kreisender Finger
Steuerungsfunktion(en):
   - Scrollen durch verschiedene Menüeinträge
   - Werteeinstellung
   - Zoom In / Out von Graphen
Geste:
   - stillstehender Finger/Verharren Steuerungsfunktion(en):
   - nach vorgegebener Zeit, z.B. 1,5 Sek., Stillstand gelangt man automatisch eine Menüebene tiefer oder aktiviert eine Werteeinstellung
Geste:
   - diagonale Wischbewegung mit Hand nach oben Steuerungsfunktion(en):
   - Eine Bedienebene zurück
   - eine Werteeinstellung deaktivieren
   - Funktion "Zurück"
Geste:
   - horizontale Wischbewegung mit Hand Steuerungsfunktion(en):
   - Scroll eines Menüs oder einer Leiste, insbesondere einer Reihe von Modulbereichen und/oder einer Geräteleiste,
   - Graphen scrollen,
   - Ziffernauswahl
Geste:
   - vertikale Wischbewegung mit Hand Steuerungsfunktion(en):
   - Scrollen von Menüs oder Tabellen,
   - Werte ändern (z.B. nach oben + und nach unten -)
Geste:
   - Hand auf Gerät zu bewegen:
      Steuerungsfunktion(en):
      - Aufwachen des Gerätes aus dem Sleep Modus /Bildschirmschoner
Geste:
   - Haltebewegung der Hand
Steuerungsfunktion(en):
   - Verriegelung Display durch zweite Annäherung

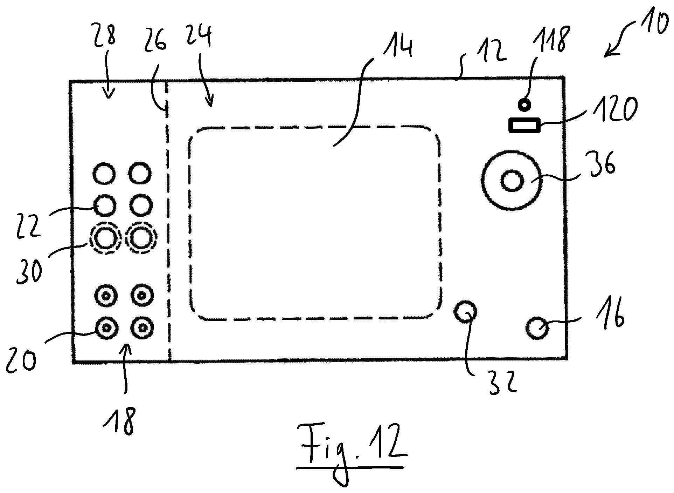

Das in Fig. 12 gezeigte Labor- und Prüfgerät 10 ähnelt den mit Bezug auf die Fig. 1 bis 11 beschriebenen Labor- und Prüfgeräten, wobei die Bezugszeichen entsprechend vergeben sind und insoweit auf die obigen Ausführungen verwiesen wird. Grundsätzlich können alle zu den Fig. 1 bis 11 beschriebenen Merkmale und Funktionen auch bei dem in Fig. 12 gezeigten Labor- und Prüfgerät realisiert sein.

Das Labor- und Prüfgerät 10 der Fig. 12 weist ein Mikrofon 118 auf, über welches das Labor- und Prüfgerät 10 eingerichtet ist, Spracheingaben entgegenzunehmen. Zudem umfasst das Labor- und Prüfgerät 10 insbesondere eine hier nicht näher dargestellte Steuereinrichtung, die zur Verarbeitung einer über das Mikrofon 118 entgegengenommenen Spracheingabe eingerichtet ist. Die Steuereinrichtung kann beispielsweise von einer der vorstehend genannten Steuereinheiten umfasst sein. Ferner umfasst das Gerät 10 eine Tonausgabeeinrichtung 120, beispielsweise einen Lautsprecher, zur Ausgabe von akustischem Feedback, insbesondere nach einer Spracheingabe.

Die Labor- und Prüfgeräte 10 der Fig. 1 bis 11 können z.B. zusätzlich ein Mikrofon und/oder eine Tonausgabeeinrichtung aufweisen. Für alle Geräte 10 der Fig. 1 bis 12 kann alternativ oder zusätzlich eine Steuerung über ein Mikrofon an einer separaten elektronischen Einheit, z.B. einem Smartphone und/oder einem Headset, vorgesehen sein.

Das Labor- und Prüfgerät 10 der Fig. 12 kann mit besonderem Vorteil einen Gestensensor aufweisen, über den das Gerät 10 durch berührungslose Gesten steuerbar ist. Der Gestensensor kann beispielsweise entsprechend dem Gestensensor 90 in Fig. 8 hinter dem Bedienelement 36 angeordnet sein. Alternativ oder zusätzlich kann beispielsweise ein separates Bedienmodul entsprechend dem Bedienmodul 102 gemäß Fig. 10 vorgesehen sein, welches bevorzugt ebenfalls einen Gestensensor 90 aufweisen kann.

### Bezugszeichenliste

- 10: Labor- und Prüfgerät
- 12: Frontplatte
- 14: Bildschirm
- 16: Ein/Aus-Schalter
- 18: Anschluss
- 20: BNC-Buchse
- 22: Buchse
- 24: Bedienfeld
- 26: Linie
- 28: Anschlussfeld
- 30: Leuchtelement
- 32: Schalter
- 34: Bedienelement
- 36: Bedienelement
- 38: Profilelement
- 40: Grundkörper
- 42: Fronteinheit
- 44: Schiene
- 46: Sicherungsstück
- 48: Magnet
- 50: Schnittstelle
- 52: Verkleidung
- 54: Grundplatte
- 56: Befestigungssockel
- 58: Funktionsmodul
- 60: Schnittstelle
- 62: Bus
- 64: Platine
- 66: Deckplatte
- 68: Körper
- 70: Einschub
- 72: Loch
- 74: Bedienelement
- 76: Modulbereich
- 78: Pfeil
- 80: Abschnitt
- 90: Gestensensor
- 92: Vertiefung
- 94: erste Seite
- 96: zweite Seite
- 98: elektrisches Feld
- 100: Labor- und Prüfgerätesystem
- 102: Bedienmodul
- 104: Bedienelement
- 106: Anschluss
- 108: Verbindungsleitung
- 110: Anschluss
- 112: Translationsgeste
- 114: Translationsgeste
- 116: Kreisgeste
- 118: Mikrofon
- 120: Tonausgabeeinrichtung
- 200: Gehäuse
- 202: Magnet
- 204: Magnethalterung
- 206: Gewindestreifen
- 208: Schraube
- 210: Platine
- 212: Steuerungseinheit
- 214: Komponente

## Patentansprüche

1. Elektronisches Labor- und Prüfgerät (10), insbesondere für ein Elektroniklabor, welches durch berührungslose Gesten (112, 114, 116) steuerbar ist und eine zumindest teilweise ebene Frontplatte (12) sowie einen auf einer dem Bediener abgewandten Seite der Frontplatte (12) angeordneten Gestensensor (90) zur Erfassung der berührungslosen Gesten (112, 114, 116) aufweist, wobei eine jeweilige berührungslose Geste (112, 114, 116) eine Bewegung parallel zur Erstreckungsebene der Frontplatte umfasst,
**dadurch gekennzeichnet,**
**dass** mittels einer berührungslosen Rotationsgeste eines aus einer Vielzahl von auf einem Bildschirm (14) des Geräts (10) angezeigten Funktionselementen auswählbar ist, wobei das Gerät (10) dazu eingerichtet ist, dass bei Durchführung der Rotationsgeste die Funktionselemente in einer vorgegebenen Reihenfolge nacheinander ausgewählt werden und nach einer Auswahl mittels der Rotationsgeste mittels eines Verharrens die Auswahl bestätigbar ist, insbesondere die dem Funktionselement zugeordnete Funktion endgültig auswählbar und/oder zur Veränderung aktivierbar ist.

2. Elektronisches Labor- und Prüfgerät (10) nach Anspruch 1,
**dadurch gekennzeichnet,**
**dass** eine berührungslose Geste, durch die das Gerät (10) steuerbar ist, eine, insbesondere vertikale und/oder horizontale, Translationsgeste (112, 114) ist, insbesondere eine Wischgeste ist.

3. Elektronisches Labor- und Prüfgerät (10) nach Anspruch 1 oder 2,
**dadurch gekennzeichnet,**
**dass** das Gerät (10) zur Erkennung von Gesten (112, 114, 116) in zwei oder drei Raumrichtungen eingerichtet ist und/oder dass das Gerät (10) durch zweidimensionale und/oder dreidimensionale berührungslose Gesten (112, 114, 116) steuerbar ist.

4. Elektronisches Labor- und Prüfgerät (10) nach wenigstens einem der vorstehenden Ansprüche, **dadurch gekennzeichnet,**
**dass** wenigstens ein Paar von Gesten (112, 114, 116) definiert ist, welche auf derselben Bahn verlaufen aber in ihrer Richtung entgegengesetzt sind, insbesondere wobei die Gesten (112, 114, 116) in ihren Steuerungsfunktionen ebenfalls einander entgegengesetzt sind, oder
**dass** wenigstens ein Paar von Gesten definiert ist, welche auf derselben Bahn verlaufen aber in ihrer Richtung entgegengesetzt sind, wobei eine erste Geste des Paars in einer ersten Richtung zu einer Erhöhung eines vom Gerät bereitgestellten physikalischen Parameters führt, wohingegen eine zweite Geste des Paars in einer zweiten Richtung zu einer Verringerung des physikalischen Parameters führt.

5. Elektronisches Labor- und Prüfgerät (10) nach wenigstens einem der vorstehenden Ansprüche, **dadurch gekennzeichnet,**
**dass** durch wenigstens eine berührungslose Geste (112, 114, 116) eine grafische Funktion des Geräts (10) und/oder eines Funktionsmoduls (58) des Geräts (10) steuerbar ist, insbesondere
eine auf einem Bildschirm (14) angezeigte Tabelle, Liste und/oder Reihe scrollbar ist,
eine auf einem Bildschirm (14) angezeigte Diagrammauftragung in ihrer Achsenauflösung einstellbar, insbesondere zoombar, ist und/oder zwischen mehreren wählbaren Ansichten einer Anzeige- und/oder Steueroberfläche des Geräts auswählbar ist.

6. Elektronisches Labor- und Prüfgerät (10) nach wenigstens einem der vorstehenden Ansprüche, **dadurch gekennzeichnet,**
**dass** der Gestensensor (90) außerdem zur Erfassung einer Berührung zur Steuerung des Geräts (10) ausgebildet ist, insbesondere wobei das Gerät (10) ein berührungsempfindliches Bedienelement (36) umfasst, wobei der Gestensensor (90) außerdem zur Erfassung einer Berührung des Bedienelements (36), insbesondere von Berührungsgesten, zur Steuerung des Geräts (10) eingerichtet ist und/oder
insbesondere wobei der Gestensensor (90) dazu eingerichtet ist, ein elektrisches Feld (98) zu erzeugen, eine Veränderung des elektrischen Feldes (98) durch eine Hand eines Benutzers zu erkennen und in Abhängigkeit von der Veränderung eine berührungslose Geste (112, 114, 116) und/oder Berührung zur Steuerung des Geräts (10) zu ermitteln.

7. Elektronisches Labor- und Prüfgerät (10) nach wenigstens einem der vorstehenden Ansprüche, **dadurch gekennzeichnet,**
**dass** das Gerät (10) mittels Spracheingabe steuerbar ist.

8. Elektronisches Labor- und Prüfgerät (10) nach wenigstens einem der vorstehenden Ansprüche, **dadurch gekennzeichnet,**
**dass** das Gerät (10) durch berührungslose Gesten und/oder mittels Spracheingabe berührungslos zumindest im Wesentlichen vollständig steuerbar ist.

9. Elektronisches Labor- und Prüfgerät (10) nach Anspruch 7 oder 8,
**dadurch gekennzeichnet,**
**dass** das Gerät (10) ein Mikrofon (118) zum Empfang der Spracheingabe aufweist und/oder
**dass** das Gerät (10) eine Steuereinrichtung zur Verarbeitung der Spracheingabe und entsprechenden Ansteuerung des Geräts (10) aufweist, wobei die Steuereinrichtung zum Erkennen mehrerer vordefinierter Sprachbefehle eingerichtet ist.

10. Elektronisches Labor- und Prüfgerät (10) nach wenigstens einem der vorstehenden Ansprüche, **dadurch gekennzeichnet,**
**dass** das Gerät (10) mehrere Funktionsmodule (58), z.B. DC-Netzteil, AC-Netzteil, Arbiträrgenerator, Datenlogger, Multimeter, Funktionsgenerator, Leistungsmesser, Hochspannungsprüfgerät, Isolationsprüfgerät, Schutzleiterprüfgerät, Ableitstromprüfgerät und/oder Funktionsprüfgerät, aufweist, wobei zumindest ein Teil der Funktionsmodule (58), bevorzugt alle Funktionsmodule (58), durch berührungslose Gesten und/oder mittels Spracheingabe steuerbar sind.

11. System umfassend ein elektronisches Labor- und Prüfgerät (10), insbesondere für ein Elektroniklabor, nach einem der vorstehenden Ansprüche und einen zusätzlichen Gestensensor (90) zur Erfassung von berührungslosen Gesten (112, 114, 116) zur Steuerung des Geräts (10), wobei der zusätzliche Gestensensor (90) am Gerät (10) und/oder an einem von dem Gerät (10) separaten und mit diesem verbundenen Bedienmodul (100) für das Gerät (10) angeordnet ist, insbesondere wobei ein berührungsempfindliches Bedienelement (36, 102) am Gerät (10) und/oder am Bedienmodul (100) angeordnet ist.

12. Verfahren zum Betrieb eines elektronischen Labor- und Prüfgeräts, insbesondere für ein Elektroniklabor, nach einem der Ansprüche 1 bis 10 oder eines Systems nach Anspruch 11,
wobei eine Geste (112, 114, 116) einer Hand eines Bedieners des Geräts (10) berührungslos erfasst wird und wobei das Gerät (10) anhand der Geste (112, 114, 116) gesteuert wird.

## Claims

1. An electronic laboratory and test device (10), in particular for an electronics laboratory, which can be controlled by non-contact gestures (112, 114, 116) and which has an at least partly planar front panel (12) and a gesture sensor (90), which is arranged on a side of the front panel (12) facing away from the operator, for detecting the non-contact gestures (112, 114, 116), wherein a respective non-contact gesture (112, 114, 116) comprises a movement parallel to the plane of extent of the front panel,
**characterized in that**
one of a plurality of functional elements displayed on a screen (14) of the device (10) can be selected by means of a non-contact rotation gesture, wherein the device (10) is configured such that, on the execution of the rotation gesture, the functional elements are selected one after another in a predefined sequence and, after a selection by means of the rotation gesture, the selection can be confirmed by means of a pause, in particular the function assigned to the functional element can be finally selected and/or can be activated for a change.

2. An electronic laboratory and test device (10) according to claim 1,
**characterized in that**
a non-contact gesture by which the device (10) can be controlled is a translation gesture (112, 114), in particular a vertical and/or horizontal translation gesture, in particular a swiping gesture.

3. An electronic laboratory and test device (10) according to claim 1 or 2,
**characterized in that**
the device (10) is configured to recognize gestures (112, 114, 116) in two or three spatial directions and/or **in that** the device (10) can be controlled by two-dimensional and/or three-dimensional non-contact gestures (112, 114, 116).

4. An electronic laboratory and test device (10) according to at least one of the preceding claims, **characterized in that**
at least one pair of gestures (112, 114, 116) is defined that extend on the same path but are opposite in their direction, in particular wherein the gestures (112, 114, 116) are likewise opposite one another in their control functions, or
**in that** at least one pair of gestures is defined that extend on the same path but are opposite in their direction, wherein a first gesture of the pair in a first direction leads to an increase of a physical parameter provided by the device, whereas a second gesture of the pair in a second direction leads to a decrease of the physical parameter.

5. An electronic laboratory and test device (10) according to at least one of the preceding claims, **characterized in that**
a graphic function of the device (10) and/or of a functional module (58) of the device (10) can be controlled by at least one non-contact gesture (112, 114, 116), in particular
a table, a list and/or a row displayed on a screen (14) is scrollable,
a plotted diagram displayed on a screen (14) is settable, in particular zoomable, in its axis resolution and/or
a selection can be made between a plurality of selectable views of a display surface and/or control surface of the device.

6. An electronic laboratory and test device (10) according to at least one of the preceding claims, **characterized in that**
the gesture sensor (90) is furthermore configured to detect a contact for controlling the device (10), in particular wherein the device (10) comprises a touch-sensitive operating element (36), wherein the gesture sensor (90) is furthermore configured to detect a contact of the operating element (36), in particular contact gestures, for controlling the device (10), and/or in particular wherein the gesture sensor (90) is configured to generate an electric field (98), to recognize a change in the electric field (98) caused by a hand of a user and, in dependence on the change, to determine a non-contact gesture (112, 114, 116) and/or a contact for controlling the device (10).

7. An electronic laboratory and test device (10) according to at least one of the preceding claims, **characterized in that**
the device (10) can be controlled by means of voice input.

8. An electronic laboratory and test device (10) according to at least one of the preceding claims, **characterized in that**
the device (10) is at least substantially completely controllable by non-contact gestures and/or by means of voice input in a contact-free manner.

9. An electronic laboratory and test device (10) according to claim 7 or 8, **characterized in that**
the device (10) has a microphone (118) for receiving the voice input, and/or in that the device (10) has a control device for processing the voice input and for a corresponding control of the device (10), with the control device being configured to recognize a plurality of predefined voice commands.

10. An electronic laboratory and test device (10) according to at least one of the preceding claims, **characterized in that**
the device (10) has a plurality of functional modules (58), e.g. a DC power supply unit, an AC power supply unit, an arbitrary waveform generator, a data logger, a multimeter, a function generator, a power meter, a highvoltage test device, an insulation test device, a protective conductor test device, a leakage current test device and/or a function test device,
wherein at least some of the functional modules (58), preferably all the functional modules (58), can be controlled by non-contact gestures and/or by means of voice input.

11. A system comprising an electronic laboratory and test device (10), in particular for an electronics laboratory, according to any one of the preceding claims and an additional gesture sensor (90) for detecting non-contact gestures (112, 114, 116) for controlling the device (10), wherein the additional gesture sensor (90) is arranged at the device (10) and/or at an operating module (100) for the device (10) that is separate from the device (10) and connected thereto, in particular wherein a touch-sensitive operating element (36, 102) is arranged at the device (10) and/or at the operating module (100).

12. A method for operating an electronic laboratory and test device, in particular for an electronics laboratory, according to any one of the claims 1 to 10 or a system according to claim 11,
wherein a gesture (112, 114, 116) of a hand of an operator of the device (10) is detected in a contact-free manner and wherein the device (10) is controlled on the basis of the gesture (112, 114, 116).

## Revendications

1. Appareil électronique de laboratoire et de test (10), en particulier pour un laboratoire d'électronique, qui peut être commandé par des gestes sans contact physique (112, 114, 116) et qui comporte une plaque frontale (12) au moins partiellement plane ainsi qu'un capteur de gestes (90) disposé sur un côté de la plaque frontale (12) détourné de l'utilisateur et destiné à détecter les gestes sans contact physique (112, 114, 116), un geste sans contact physique (112, 114, 116) respectif comprenant un mouvement parallèle au plan d'extension de la plaque frontale,
**caractérisé en ce que**
un élément fonctionnel peut être sélectionné au moyen d'un geste de rotation sans contact physique parmi une pluralité d'éléments fonctionnels affichés sur un écran d'affichage (14) de l'appareil (10), l'appareil (10) étant conçu de telle sorte que, lors de l'exécution du geste de rotation, les éléments fonctionnels sont sélectionnés les uns après les autres selon un ordre chronologique prédéfini et qu'après une sélection au moyen du geste de rotation, en restant immobile, la sélection peut être confirmée, en particulier la fonction associée à l'élément fonctionnel peut être définitivement sélectionnée et/ou activée pour être modifiée.

2. Appareil électronique de laboratoire et de test (10) selon la revendication 1,
**caractérisé en ce que**
un geste sans contact physique permettant de commander l'appareil (10) est un geste de translation (112, 114), en particulier vertical et/ou horizontal, en particulier un geste de balayage.

3. Appareil électronique de laboratoire et de test (10) selon la revendication 1 ou 2,
**caractérisé en ce que**
l'appareil (10) est configuré pour reconnaître des gestes (112, 114, 116) dans deux ou trois directions spatiales, et/ou
**en ce que** l'appareil (10) peut être commandé par des gestes sans contact physique (112, 114, 116) bidimensionnels et/ou tridimensionnels.

4. Appareil électronique de laboratoire et de test (10) selon l'une au moins des revendications précédentes,
**caractérisé en ce que**
au moins une paire de gestes (112, 114, 116) est définie, qui suivent la même trajectoire mais qui sont opposés l'un à l'autre quant à leur direction, en particulier, les gestes (112, 114, 116) étant également opposés l'un à l'autre quant à leurs fonctions de commande, ou
**en ce qu'**au moins une paire de gestes est définie, qui suivent la même trajectoire mais qui sont opposés l'un à l'autre quant à leur direction, et un premier geste de ladite paire dans une première direction entraîne une augmentation d'un paramètre physique fourni par l'appareil, tandis qu'un deuxième geste de ladite paire dans une deuxième direction entraîne une diminution du paramètre physique.

5. Appareil électronique de laboratoire et de test (10) selon l'une au moins des revendications précédentes,
**caractérisé en ce que**
au moins un geste sans contact physique (112, 114, 116) permet de commander une fonction graphique de l'appareil (10) et/ou d'un module fonctionnel (58) de l'appareil (10), en particulier
un tableau, une liste et/ou une série, affichés sur un écran d'affichage, (14) peuvent être défilés,
un tracé de diagramme affiché sur un écran d'affichage (14) peut être réglé quant à sa résolution d'axe, en particulier être zoomé, et/ou une vue parmi plusieurs vues sélectionnables d'une surface d'affichage et/ou de commande de l'appareil peut être sélectionnée.

6. Appareil électronique de laboratoire et de test (10) selon l'une au moins des revendications précédentes,
**caractérisé en ce que**
le capteur de gestes (90) est en outre conçu pour détecter un contact physique destiné à commander l'appareil (10), en particulier l'appareil (10) comprend un élément de manœuvre tactile (36),
le capteur de gestes (90) est en outre conçu pour détecter un contact physique avec l'élément de manœuvre (36), en particulier des gestes tactiles, pour commander l'appareil (10), et/ou
en particulier, le capteur de gestes (90) est conçu pour générer un champ électrique (98), pour détecter une modification du champ électrique (98) par la main d'un utilisateur, et pour déterminer, en fonction de la modification, un geste sans contact physique (112, 114, 116) et/ou un contact physique destiné à commander l'appareil (10).

7. Appareil électronique de laboratoire et de test (10) selon l'une au moins des revendications précédentes,
**caractérisé en ce que**
l'appareil (10) peut être commandé par commande vocale.

8. Appareil électronique de laboratoire et de test (10) selon l'une au moins des revendications précédentes,
**caractérisé en ce que**
l'appareil (10) peut être commandé, au moins sensiblement en totalité sans contact physique, par des gestes sans contact physique et/ou par commande vocale.

9. Appareil électronique de laboratoire et de test (10) selon la revendication 7 ou 8,
**caractérisé en ce que**
l'appareil (10) comporte un microphone (118) pour recevoir la commande vocale, et/ou
**en ce que** l'appareil (10) comporte un dispositif de commande pour traiter la commande vocale et commander l'appareil (10) en correspondance, le dispositif de commande étant conçu pour reconnaître plusieurs instructions de commande vocale prédéfinies.

10. Appareil électronique de laboratoire et de test (10) selon l'une au moins des revendications précédentes,
**caractérisé en ce que**
l'appareil (10) comprend plusieurs modules fonctionnels (58), par exemple un bloc d'alimentation en courant continu, un bloc d'alimentation en courant alternatif, un générateur arbitraire, un enregistreur de données, un multimètre, un générateur de fonctions, un wattmètre, un appareil de test haute tension, un appareil de contrôle d'isolation, un appareil de contrôle de conducteur de protection, un appareil de contrôle de courant de fuite et/ou un appareil de contrôle de fonction, au moins une partie des modules fonctionnels (58), de préférence tous les modules fonctionnels (58), pouvant être commandés par des gestes sans contact physique et/ou par commande vocale.

11. Système comprenant un appareil électronique de laboratoire et de test (10), en particulier pour un laboratoire d'électronique, selon l'une des revendications précédentes, et un capteur de gestes supplémentaire (90) pour détecter des gestes sans contact physique (112, 114, 116) destinés à commander l'appareil (10), le capteur de gestes supplémentaire (90) étant disposé sur l'appareil (10) et/ou sur un module (100) de manœuvre de l'appareil (10), qui est séparé de l'appareil (10) et relié à celui-ci, en particulier un élément de manœuvre tactile (36, 102) étant disposé sur l'appareil (10) et/ou sur le module de manœuvre (100).

12. Procédé pour faire fonctionner un appareil électronique de laboratoire et de test, en particulier pour un laboratoire d'électronique, selon l'une des revendications 1 à 10, ou un système selon la revendication 11,
dans lequel un geste (112, 114, 116) d'une main d'un utilisateur de l'appareil (10) est détecté sans contact physique, et l'appareil (10) est commandé à l'aide du geste (112, 114, 116).
